# FASCICULE DE BREVET EUROPEEN

(11) **EP 2 862 836 B1**
(45) Date de publication et mention de la délivrance du brevet: **25.05.2016**
(21) Numéro de dépôt: 14189171.3
(22) Date de dépôt: 16.10.2014
(51) Int. Cl.: B81C 1/00

(54) **Procédé de réalisation par voie électrochimique d'au moins une zone poreuse d'une structure micro et/ou nanoélectronique**
Elektrochemisches Herstellungsverfahren mindestens einer porösen Zone einer mikro- und/oder nanoelektrischen Struktur
Method for electrochemically producing at least one porous region of a micro- and/or nanoelectronic structure

(30) Priorité: 16.10.2013 FR 1360078
(43) Date de publication de la demande: 22.04.2015
(73) Titulaire: Commissariat à l'Énergie Atomique et aux Énergies Alternatives, 75015 Paris (FR)
(72) Inventeur: Ollier, Eric, 38100 Grenoble (FR); Gaillard, Frédéric-Xavier, 38500 Voiron (FR); Marcoux, Carine, 38500 Voiron (FR)
(74) Mandataire: Brevalex

(56) Documents cités:
- YA ANDRUSHIN S ET AL: "Formation of porous silicon on a non-conductive substrate and its use as a sacrificial layer; Formation of porous silicon on non-conductive substrate", SEMICONDUCTOR SCIENCE AND TECHNOLOGY, IOP PUBLISHING LTD, GB, vol. 20, no. 12, 15 novembre 2005 (2005-11-15), pages 1217-1222, XP020086409, ISSN: 0268-1242, DOI: 10.1088/0268-1242/20/12/013

## Description

### DOMAINE TECHNIQUE ET ART ANTÉRIEUR

La présente invention se rapporte à un procédé de réalisation d'au moins une zone poreuse d'une structure microélectronique et/ou nanoélectronique dans au moins une partie d'une couche conductrice ou semi-conductrice électrique, ladite zone poreuse étant formée par voie électrochimique.

Les dispositifs microélectroniques et microsystèmes, dont les systèmes microélectromécaniques ou MEMS (MicroElectroMEchanical System) et les systèmes nanoélectromécaniques ou NEMS (NanoElectroMEchanical System) sont couramment employés dans de nombreux produits de la vie courante.

Pour certains de ces systèmes, il est intéressant de réaliser des couches poreuses. Selon les applications, on cherchera à utiliser des propriétés particulières de ces matériaux poreux, par exemple il peut s'agir de leur capacité d'absorption chimique qui peut être mise en oeuvre dans les capteurs chimiques, biologiques, d'humidité, etc., leur capacité d'isolation thermique, leur capacité d'isolation électrique, leurs propriétés optiques, etc.

Dans les NEMS ET les MEMS, les matériaux semi-conducteurs sont utilisés de manière importante, en particulier le silicium.

Les éléments poreux ou des parties d'élément poreux qui sont utilisés par de nombreux NEMS et MEMS sont en matériau semi-conducteur poreux plus particulièrement en silicium poreux.

Il existe de nombreux procédés permettant de former du silicium poreux à la surface d'un substrat en silicium ou de structures MEMS dans des configurations très variées, et également des procédés permettant de réaliser des structures mobiles de type MEMS entièrement en silicium poreux ou partiellement recouvertes de silicium poreux sur certaines de leurs surfaces.

Il est connu de réaliser des structures mécaniques suspendues entièrement en silicium poreux ou de former uniquement une couche poreuse sur un élément en silicium poreux. Par exemple, le document EP 1 683 757 décrit un procédé de réalisation d'un MEMS comportant une étape de réalisation d'une couche en silicium poreux par gravure électrochimique. Ce procédé de porosification nécessite le passage d'un courant électrique entre les faces arrière, et la face avant où l'on souhaite former le silicium poreux du substrat. Ce procédé implique donc de partir d'un substrat conducteur électrique. Ce procédé ne peut donc pas être mis en oeuvre sur des substrats comportant une couche isolante, tels que les substrats SOI (Silicon on Insulator) ou silicium sur isolant. Or ce type de substrat est très souvent utilisé pour fabriquer des systèmes micro et nanoélectroniques.

Le document *"* Composite porous silicon-crystalline silicon cantilevers for enhanced biosensing" S. Stolyarova, S. Cherian, R. Raiteri, J. Zeravik, P. Skladal, Y. Nemirovsky, Sensors and Actuators B 131 (2008) 509-515 décrit un transducteur comportant une poutre de type cantilever en silicium poreux. Celui-ci est réalisé à parti d'un substrat SOI. Le silicium poreux est formé en exposant le silicium monocristallin à des vapeurs qui en le gravant le porosifie. Cette technique est parfois appelée « stain-etching ». Elle est également décrite par exemple dans le document « Vapor-etching-based porous silicon formation », M. Saadoun, N. Mliki, H. Kaabi, K. Daoubi, B. Bessais, H. Ezzaouia, R.Bennaceur, Vapour-etching-based porous silicon: a new approach, Thin Solid Films 405 (2002) 29-34*.* Cette technique, également appelée Reactive Induced Vapor Phase Stain Etch (RIVPSE), consiste à exposer le substrat à des vapeurs produites par la gravure de silicium dans un mélange HF: HNO₃: CH₃COOH. Ce procédé ne nécessite pas de faire circuler un courant électrique entre les deux faces du substrat. En revanche, ce procédé ne permet pas un bon contrôle du procédé en termes de vitesse de formation du SiP (abréviation de Silicium Poreux), de taux de porosité, de diamètre des pores, etc.

Au contraire, le procédé de gravure électrochimique, également appelé "anodization technique" en anglais, est beaucoup mieux maîtrisé. Il repose sur le fait que la porosification est obtenue par dissolution anodique en présence d'acide fluorhydrique. Ce procédé permet d'assurer un bon contrôle des vitesses de formation du SiP, des taux de porosité, des diamètres des pores, etc. Il est capable d'offrir des porosités différentes (microporeux/diamètre des pores < 2nm, mésoporeux/ diamètre des pores compris entre 2 nm-50 nm, macroporeux/ diamètre des pores > 50 nm), des orientations particulières des pores, etc. Les conditions d'anodisation (concentration en HF, densité de courant, temps) ainsi que le dopage (nature N ou P, concentration en dopants) du substrat permettent de contrôler les caractéristiques de la couche poreuse. Mais, comme indiqué ci-dessus, ce procédé nécessite le passage d'un courant électrique entre la face arrière et la face avant du substrat sur laquelle on souhaite créer la porosité, ce qui explique qu'il ne peut pas être mis en oeuvre simplement sur des substrats comportant une couche isolante, comme les substrat SOI. Ainsi ce procédé de porosification utilise un substrat dit bulk, i.e. entièrement en matériau conducteur ou semi-conducteur et ne comportant pas de couche isolante.

L'article de revue scientifique A ANDRUSHIN S ET AL: "Formation of porous silicon on a non-conductive substrate and its use as a sacrificial layer", SEMICONDUCTOR SCIENCE AND TECHNOLOGY, IOP PUBLISHING LTD, GB, vol. 20, no. 12, 15 novembre 2005 (2005-11-15), pages 1217-1222, ISSN: 0268-1242, DOI: 10.1088/0268-1242/20/12/013 décrit néanmoins un procédé de gravure électrochimique qui utilise un substrat SOI. Ce procédé requiert la formation d'un contact électrique en forme de boucle sur la couche active. La zone de porosification est délimitée par un anneau en polymère à l'intérieur du contact électrique.

Il existe des exemples de réalisation de surfaces de silicium poreux sur des substrats par exemple SOI par transferts de couches à base de techniques de scellement par exemple de scellement moléculaire. Mais ce sont des techniques coûteuses et qui ne sont pas facilement applicables pour la mise en oeuvre sur des structures micro et nanoélectroniques, en particulier dans le cas où l'on souhaite localiser la ou les zones poreuses.

### EXPOSÉ DE L'INVENTION

C'est par conséquent un but de la présente invention d'offrir un procédé de réalisation d'au moins une zone poreuse d'une structure microélectronique et/ou nanoélectronique dans au moins une partie d'une couche conductrice ou semi-conductrice électrique portée par un support conducteur ou semi-conducteur et séparée de celui-ci par une couche isolante électrique, la zone poreuse étant formée par voie électrochimique.

Le but précédemment énoncé est atteint par un procédé comportant une étape de réalisation d'au moins une liaison électrique entre la couche conductrice ou semi-conductrice formant face avant et le support conducteur ou semi-conducteur formant face arrière à travers la couche isolante préalablement à la formation de la zone poreuse dans la couche conductrice et l'étape de porosification par gravure électrochimique d'une partie au moins de la couche conductrice ou semi-conductrice.

Cette liaison électrique entre la face avant et la face arrière permet de faire circuler un courant électrique entre ces deux faces et donc de graver par voie électrochimique la face avant afin de rendre poreuse au moins une partie de la face avant.

De préférence, plusieurs liaisons électriques sont réalisées entre la face avant et la face arrière à travers le substrat, permettant une meilleure maîtrise de la porosité de la zone à former.

Avantageusement la liaison électrique ou la pluralité de liaisons électriques est formée par des blocs de contact en matériau conducteur ou semi-conducteur à travers le matériau isolant.

Dans un exemple de réalisation, la structure est formée à partir d'un substrat SOI. De préférence le ou les contacts électriques est/ sont alors réalisés par épitaxie. Dans un autre exemple de réalisation, le procédé consiste à partir d'un empilement d'au moins une couche conductrice ou semi-conductrice formant face arrière et une couche isolante, à réaliser une ou des gravures dans la couche isolante et ensuite à former le ou les plots de contact et la couche active, simultanément ou non.

La liaison électrique entre la couche conductrice et le substrat porteur peut être conservée dans le système final. De manière préférée, la ou les liaisons électriques sont interrompues, ce qui permet d'isoler électriquement plusieurs structures microélectroniques ou nanoélectroniques d'un même dispositif ou alors d'isoler des dispositifs réalisés sur le même substrat. La suppression de la ou des liaisons électriques peut être obtenue par exemple par gravure au moins partielle du ou des plots de contact ou par retrait par découpe des plots de contact.

La présente invention a alors pour objet un procédé de réalisation d'au moins une zone poreuse dans au moins une partie d'une couche active en matériau conducteur ou semi-conducteur d'une structure microélectronique et/ou nanoélectronique , ladite couche active formant une face avant d'un empilement, ledit empilement comportant une face arrière en matériau conducteur ou semi-conducteur et une couche isolante électrique interposée entre la couche active et la face arrière, ledit procédé comportant les étapes :
a) réalisation d'au moins un contact électrique entre la face arrière et la couche active par formation d'au moins un bloc de contact en matériau conducteur électrique ou semi-conducteur à travers la couche isolante,
b) mise en place de l'empilement dans un bain électrochimique,
c) application d'un courant électrique entre la face arrière et la couche active à travers le bloc de contact de sorte à induire une porosification d'au moins une zone de la couche active.

Le bloc de contact peut être formé à partir de la face avant et/ou à partir de la face arrière.

Le procédé de réalisation peut avantageusement comporter, après l'étape c), une étape d) de formation de la structure microélectronique et/ou nanoélectronique, à partir de la couche active, par exemple par gravure de la couche active.

Cette étape de formation peut comporter une ou plusieurs étapes choisies parmi, le dopage, la structuration, l'épitaxie, la reprise de contact de la couche active. Dans le mode de réalisation où le contact est supprimé, l'étape d) peut être réalisée avant, après ou pendant, cette étape de suppression du contact.

De préférence, l'empilement est un substrat SOI.

Dans un mode de réalisation, le contact électrique entre la couche active et la face arrière est supprimé après l'étape c). L'étape de suppression du contact électrique peut être obtenue par retrait au moins partiel du bloc de contact de sorte à supprimer un contact mécanique entre la couche active et/ou la face arrière et le bloc de contact.

Selon un exemple de réalisation, le bloc de contact peut être partiellement gravé et/ou la couche active est gravée autour du bloc de contact.

L'étape d) peut comporter une sous-étape de gravure de la couche active, le retrait au moins partiel du bloc de contact ayant lieu simultanément à la gravure de la couche active.

Selon un autre exemple de réalisation, le bloc de contact est retiré par sciage.

Dans un mode de réalisation, l'étape a) comporte la réalisation d'au moins un trou à travers l'empilement entre la face arrière et la couche active, à travers la couche isolante et le remplissage dudit trou par un matériau conducteur électrique ou semi-conducteur de sorte à former le bloc de contact établissant un contact électrique entre la face arrière et la couche active.

L'étape de remplissage dudit trou par un matériau conducteur électrique ou semi-conducteur est obtenu de préférence par épitaxie sélective ou non, électrolyse ou dépôt de type CVD. Avantageusement, il s'agit d'une épitaxie sélective, ce qui permet de ne remplir que l'emplacement du bloc de contact.

Dans un autre mode de réalisation, préalablement à l'étape a), au moins un trou est réalisé dans la couche isolante atteignant la face arrière et lors de l'étape a), la couche active et le bloc de contact sont formés simultanément sur la couche isolante et dans le trou respectivement.

La formation de la couche active et du bloc de contact peuvent être effectuée par épitaxie. Par exemple, il s'agit d'une épitaxie de silicium à partir d'un support en silicium.

De préférence, le matériau du bloc de contact et celui de la couche active sont les mêmes.

Dans un exemple de réalisation, lors de l'étape a) plusieurs blocs de contact distincts sont réalisés à proximité de la zone à porosifier. Avantageusement, ces blocs de contacts forment un contour discontinu autour de la zone à porosifier.

Dans un autre exemple de réalisation, lors de l'étape a) un seul bloc de contact présentant un contour fermé est réalisé, la zone à porosifier étant à l'intérieur et/ou à l'extérieur du contour fermé.

Lors de l'étape a) un seul bloc de contact présentant un contour discontinu est réalisé, la zone à porosifier étant à l'intérieur et/ou à l'extérieur du contour discontinu, ou une pluralité de blocs de contact délimitant entre eux une zone est réalisée, la zone à porosifier étant à l'intérieur et/ou à l'extérieur de la dite zone.

Par exemple, lors de l'étape c) toute la surface de la couche active est porosifiée et/ou la couche active est porosifiée sur toute son épaisseur.

Dans un autre exemple, préalablement à l'étape c) une couche de localisation est formée au moins sur la couche active pour délimiter au moins une zone de la couche active à porosifier.

Avantageusement dans le cas où une structure microélectronique et/ou nanoélectronique est réalisée, des blocs de contact entourent la zone dans laquelle la structure microélectronique et/ou nanoélectronique est réalisée.

La structure microélectronique et/ou nanoélectronique peut comporter au moins une partie suspendue et une partie fixe, la zone poreuse peut alors être formée au moins en partie sur la partie suspendue et éventuellement au moins en partie sur la partie fixe. La partie suspendue peut être mobile ou pas.

Le bloc de contact peut être réalisé dans une zone entre la partie fixe et la partie suspendue.

L'étape d) peut comporter la réalisation d'interconnexions sur la couche active comprenant les sous-étapes :
- formation d'une couche diélectrique sur la zone poreuse et sur la couche active,
- formation d'un masque sur la couche diélectrique,
- gravure du masque et de la couche diélectrique jusqu'à atteindre la couche active,
- formation et structuration d'un matériau conducteur dans les gravures pour former les interconnexions,

Lorsque le procédé comporte une étape de libération de la structure mécanique, le retrait du masque et de la couche diélectrique peut avoir lieu lors de la libération finale de la structure mécanique.

La formation du matériau conducteur est réalisée par exemple par dépôt pleine plaque du matériau conducteur et lithogravure dudit matériau pour former les interconnexions et éventuellement des lignes de connexion ou gravure par polissage mécano-chimique du matériau conducteur de sorte à ne garder du matériau conducteur que dans les gravures.

L'empilement peut comporter une ou plusieurs couches entre la face arrière et la couche isolante telles qu'une continuité électrique entre la face arrière et la couche active est assurée après l'étape a).

Dans le cas où le procédé est destiné à la réalisation de plusieurs structures microélectroniques et/ou nanoélectroniques, les blocs de contacts peuvent être réalisés entre les zones dans lesquelles les structures microélectroniques et/nanoélectroniques sont réalisées.

Le contact électrique entre la couche active et la face arrière peut alors être supprimé après l'étape c) par séparation des structures microélectroniques et/ou nanoélectroniques.

La séparation des structures microélectroniques et/ ou nanoélectroniques est par exemple obtenue par sciage, par deux traits de scie de part et d'autre des plots de contact de sorte à séparer les blocs de contacts des structures microélectronique et/ou nanoélectroniques ou par un trait de scie ayant une largeur au moins égale à la dimension transversale des blocs de contact.

### BRÈVE DESCRIPTION DES DESSINS

La présente invention sera mieux comprise à l'aide de la description qui va suivre et des dessins en annexe sur lesquels :
- la figure 1 est une représentation schématique d'un empilement général muni de plots de contact obtenu selon le procédé selon l'invention,
- les figures 2A et 2B sont des vues de dessus et en coupe suivant le plan A-A' respectivement d'un exemple de structure pouvant être obtenu grâce au procédé selon l'invention, la zone poreuse étant non localisée,
- la figure 3 est une vue en coupe de la structure de la figure 2A avant libération de la partie suspendue dans le cas d'une libération ultérieure,
- les figures 4A et 4B sont des vues de dessus et en coupe suivant le plan B₋B' respectivement d'un exemple de structure pouvant être obtenu grâce au procédé selon l'invention, la zone poreuse étant localisée,
- les figures 5A et 5B sont des vues de dessus et en coupe suivant le plan C-C' respectivement d'un autre exemple de structure pouvant être obtenu grâce au procédé selon l'invention, la zone poreuse étant localisée,
- les figures 6A et 6B sont des vues de dessus et en coupe suivant le plan D-D' respectivement d'un exemple de structure pouvant être obtenu grâce au procédé selon l'invention, la zone poreuse étant non localisée et le contact électrique entre la face arrière et la face active étant supprimé,
- les figures 6C et 6D sont des vues de dessus et en coupe suivant le plan E-E' respectivement d'une variante du dispositif des figures 6A et 6B dans laquelle des métallisations ont été formées sur la structure micro ou nanoélectronique,
- les figures 7A et 7B sont des vues de dessus et en coupe suivant le plan F-F' respectivement d'un exemple de structure pouvant être obtenu grâce au procédé selon l'invention, la zone poreuse étant localisée et le contact électrique entre la face arrière et la face active étant supprimé,
- les figures 8A et 8B sont des vues de dessus et en coupe suivant le plan G-G' respectivement d'un autre exemple de structure pouvant être obtenu grâce au procédé selon l'invention, la zone poreuse étant localisée et le contact électrique entre la face arrière et la face active étant supprimé,
- les figures 9A et 9B sont des vues de dessus et en coupe suivant le plan H-H' respectivement d'une variante du dispositif des figures 7A et 7B dans laquelle des métallisations ont été formées sur la structure micro ou nanoélectronique,
- les figures 10A et 10B sont des vues de dessus et en coupe suivant le plan I-I' respectivement d'une variante du dispositif des figures 8A et 8B dans laquelle des métallisations ont été formées sur la structure micro ou nanoélectronique,
- les figures 11A à 11O'' sont des représentations schématiques des différentes étapes d'un exemple de procédé de réalisation selon l'invention,
- les figures 12A à 12D sont des représentations schématiques de certaines étapes d'un autre exemple de procédé de réalisation selon l'invention,
- les figures 13A à 13L sont des représentations schématiques des différentes étapes d'un autre exemple de procédé de réalisation selon l'invention,
- les figures 14A et 14B sont des vues de dessus et en coupe suivant le plan J-J' respectivement d'un substrat sur lequel plusieurs structures microélectroniques ou nanoélectroniques ont été réalisées grâce au procédé selon l'invention,
- les figures 15A à 15L sont des vues de dessus de différents exemples de forme de bloc de contact pouvant être mis en oeuvre dans le procédé selon l'invention,
- les figures 16A à 16C sont des représentations schématiques de différentes installations de gravure électrochimique pouvant être mises en oeuvre pour la réalisation du procédé selon l'invention,
- les figures 17A à 17C sont des phots de différentes surfaces poreuses obtenues par les installations des figures 16A à 16C,
- la figure 18 représente schématiquement des vues de dessus et de côté d'une structure obtenue par le procédé selon l'invention, les blocs de contact étant gravés lors d'une étape de définition de la structure mécanique,
- la figure 19 est une vue de côté d'une structure obtenue par la procédé selon l'invention dans lequel les blocs de contact sont réalisés à partir de la face arrière.

### EXPOSÉ DÉTAILLÉ DE MODES DE RÉALISATION PARTICULIERS

Nous allons tout d'abord décrire différents dispositifs pouvant être obtenus par le procédé selon la présente invention, différents exemples de procédé de réalisation selon l'invention seront décrits par la suite.

Dans la description qui va suivre, les exemples de procédé décrits comportent généralement une étape de structuration de la couche active et une libération de la partie structurée, mais un procédé dans lequel la couche active ne serait pas structurée et/ou la partie structurée ne serait pas libérée ne sort pas du cadre de la présente invention.

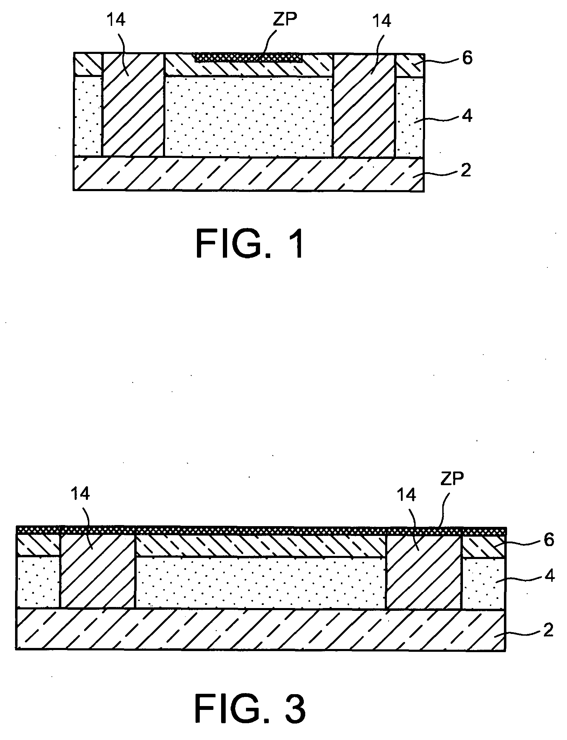

Les dispositifs sont réalisés dans une couche en matériau semi-conducteur ou conducteur électrique 6, qui forme la face avant d'un empilement comportant un substrat support ou bulk 2, et une couche en matériau diélectrique 4 interposée entre le substrat bulk 2 et la couche 6. La couche 6 sera désignée par la suite "couche active" à des fins de simplicité. Cet empilement est représenté sur la figure 1. Le substrat "support" est réalisé en un matériau semi-conducteur ou conducteur électrique.

Par exemple, la couche active 6 et le substrat support 2 peuvent être réalisés dans :
- un matériau semi-conducteur, tel que le Si, Ge, SiGe, etc... sous forme monocristalline, polycristalline, amorphe...,
- un métal tel que Al, W, voire Cu, Au,
- des composés ou multi-couches des matériaux précédents (semi-conducteurs et métaux).

Les matériaux semi-conducteurs peuvent être de type P ou de type N et peuvent avoir différents niveaux de dopage. Préférentiellement ils sont de type P+. Le dopage et sa réalisation seront décrits lors de la description des procédés de réalisation.

La couche diélectrique 4 peut être du BOX d'un substrat SOI. En variante, elle peut être en d'autres types d'oxyde, par exemple oxyde de silicium de type CVD, PVD, ICVD, etc.

Elle pourrait être en nitrure, par exemple nitrure de silicium, ou alors en semi-conducteur dopé de façon à former une isolation avec les autres semi-conducteurs entourant cette couche.

Une structure microélectronique et/ou nanoélectronique selon l'invention est une structure mécanique comportant au moins une partie sensible, cette partie sensible pouvant être un élément suspendu, cet élément suspendu pouvant être mobile ou non. L'utilisation de l'appellation « partie sensible » ne limite pas l'invention au domaine des capteurs. La partie sensible est comprise dans la présente demande comme une « partie active » ayant une fonction particulière par rapport au reste du dispositif. La structure peut comporter ou non des moyens d'actionnement, et/ou des moyens de transduction et/ou des moyens de mesure. Une telle structure peut former une structure de type transistor, une structure de type magnétique, de type optique...

Dans la description, qui va suivre la ou les structures microélectroniques et/ou nanoélectroniques seront désignées par NEMS à des fins de simplicité. Le terme NEMS s'applique aussi bien à des NEMS unitaires qu'à des réseaux de NEMS comportant un ou plusieurs niveaux d'interconnexions métalliques.

Dans la description qui va suivre, les dispositifs comportent des parties suspendues. Mais il sera compris que l'invention permet de réaliser de dispositifs sans parties suspendues.

Les termes "supérieure" et "inférieure" font référence à l'orientation des dessins par rapport à la feuille et ne sont en aucun cas limitatif, les dispositifs représentés pouvant présenter toute orientation dans l'espace.

Le procédé selon l'invention prévoit de réaliser au moins un chemin conducteur électrique 14 à travers la couche isolante 4 séparant le substrat support 2 de la couche active 6 afin de rendre poreuse au moins une partie de la couche active 6 (figure 1).

On entend par "un matériau poreux" dans la présente demande un matériau qui présente dans son volume et/ou sur sa surface des cavités (pores). Le diamètre des pores peut être compris entre quelques nm et plusieurs dizaines voire centaines de nm, avec des taux de porosités de quelques pourcents à 80 %-90%. De manière préférentielle, ces pores peuvent se rejoindre de sorte à offrir une porosité ouverte, ou non de sorte à offre une porosité fermée.

La zone poreuse, désignée ZP, formée dans la couche active peut s'étendre sur toute ou partie de la surface de la couche active 6 et sur tout ou partie de l'épaisseur de la couche active 6. En outre, la zone poreuse peut ne pas présenter une épaisseur constante.

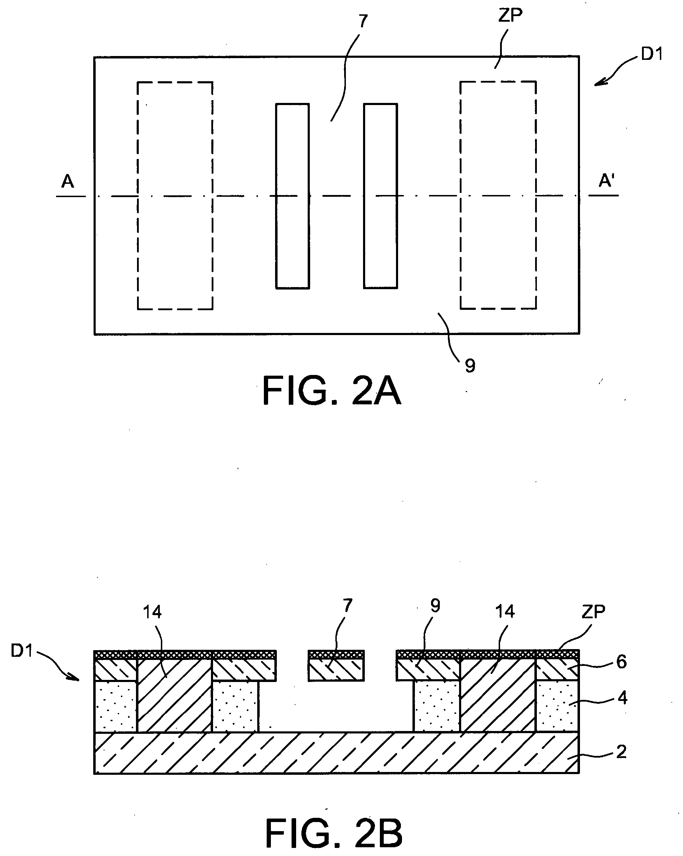

Sur les figures 2A et 2B, on peut voir un premier exemple d'un dispositif D1 obtenu grâce à la présente invention. Celui-ci comporte un NEMS formé dans la couche active 6. La surface supérieure de la couche active 6 a été porosifiée et forme la zone poreuse ZP. La zone poreuse forme toute la face avant du dispositif (figure 2A). Ainsi à la fois, la partie suspendue 7 et la partie fixe 9 comporte une face supérieure poreuse. Cette zone poreuse ZP est désignée par " zone poreuse non localisée ".

Dans cet exemple, la partie suspendue 7 a la forme d'une poutre encastrée à ses deux extrémités.

Le dispositif D1 comporte deux blocs de contact 14 ayant servi à la formation de la zone poreuse par voie électrochimique. Les blocs de contact 14 sont situés de part et d'autre de la partie suspendue 7. Dans l'exemple représenté, ils sont en forme de parallélépipède rectangle dont la plus grande longueur s'étend parallèlement à l'axe longitudinal de la partie suspendue 7.

Les blocs de contact 14 sont conducteurs électriques et sont en métal ou semi-conducteur et peuvent comporter un ou plusieurs métaux et un ou plusieurs semi-conducteurs par exemple en couche. Les blocs de contact servent à conduire le courant électrique entre le substrat support 2 et la couche active 6 afin de permettre la porosification d'une partie au moins de la couche active 6 par un procédé par voie électrochimique.

Dans le dispositif D1, le contact électrique entre le substrat support 2 et la couche active 6, plus particulièrement avec le NEMS, est conservé.

Sur la figure 3, on peut voir l'empilement comportant les blocs de contact 14 et la zone poreuse non localisée ZP avant structuration du NEMS et sa libération. Il est à noter que, en fonction des applications, l'empilement de la figure 3 pourrait être fonctionnel et le procédé de fabrication pourrait être terminé.

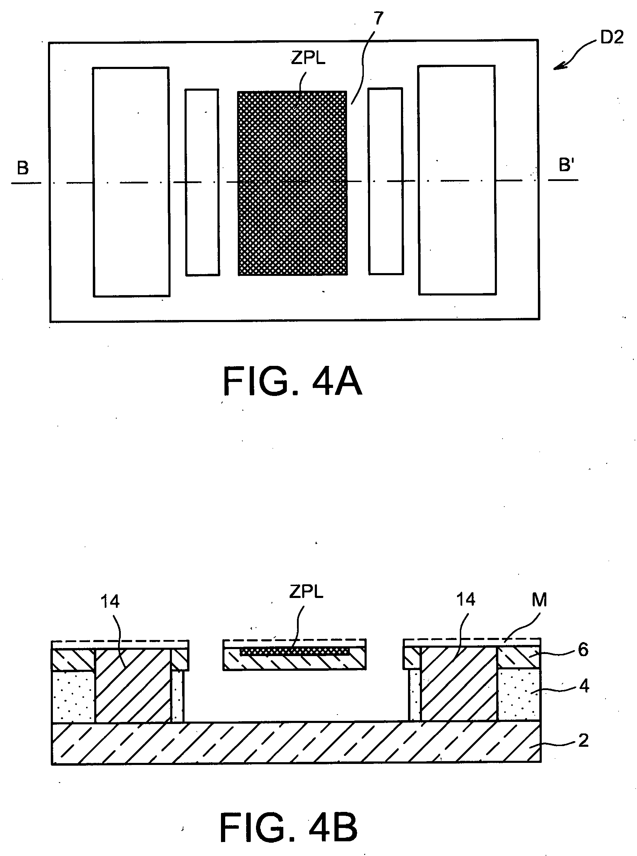

Sur les figures 4A et 4B, on peut voir un autre exemple de réalisation d'un dispositif D2 obtenu grâce à la présente invention, dans lequel la couche poreuse ZPL est localisée.

Dans cet exemple la zone poreuse ZPL forme une partie seulement de la face supérieure de la partie suspendue 7. Les blocs de contact 14 présentent des formes et des dispositions par rapport à la partie suspendue similaires à celles de la partie suspendue du dispositif D1. Dans cet exemple également, le contact électrique entre le NEMS et le substrat support 2 est conservé au moyen des blocs de contact 14. La zone poreuse localisée ZPL a été obtenue grâce à la mise en oeuvre d'un masque de localisation M qui est symbolisé par des pointillés, celui-ci ayant été retiré.

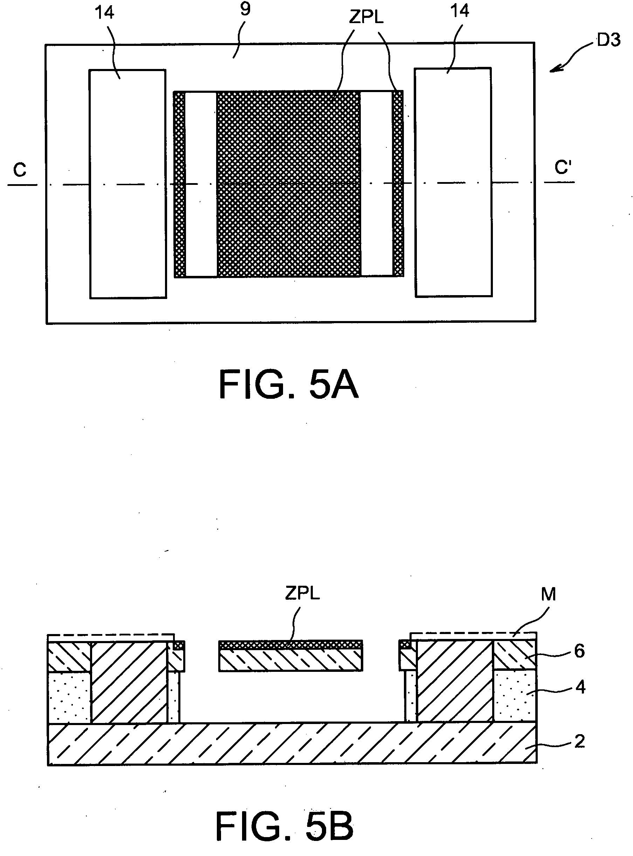

Sur la figure 5A et 5B, on peut voir un autre exemple de réalisation d'un dispositif D3 obtenu grâce à la présente invention, dans lequel la zone poreuse ZPL est également localisée. Le dispositif D3 diffère du dispositif D2 en ce que la zone poreuse localisée est à la fois présente sur la partie suspendue 7 et sur la partie fixe 9 du NEMS. Dans cette exemple toute la face supérieure de la partie suspendue 7 est poreuse. En variante, on pourrait envisager que seule une partie de la face supérieure soit poreuse. En outre, la zone poreuse est présente sur la partie fixe 9 de part et d'autre de la partie active 7 par rapport à son axe longitudinal, or on pourrait envisager qu'elle ne se trouve par exemple que d'un côté de la partie mobile. Le masque M utilisé pour localiser la zone poreuse est également représenté en pointillés.

Dans cet exemple également, le contact électrique au moyen des blocs de contact 14 entre le NEMS et le substrat support 2 est conservé. Les blocs de contact 14 présentent des formes et des dispositions par rapport à la partie suspendues similaires à celles des blocs de contact du dispositif D1.

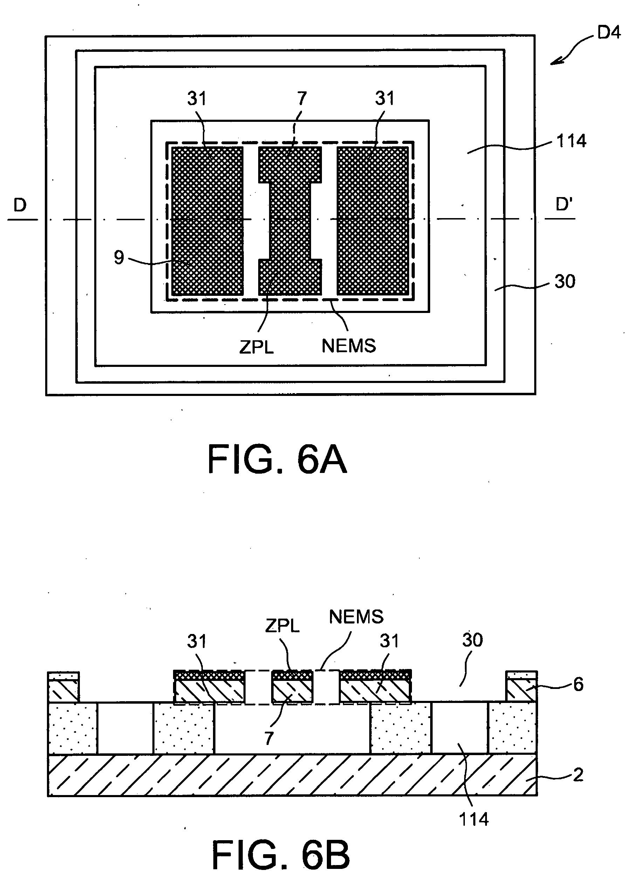

Sur les figures 6A et 6B, on peut voir un autre exemple de réalisation d'un dispositif D4 obtenu grâce à la présente invention, dans lequel le contact électrique entre la couche support 2 et le NEMS a été supprimé après formation de la zone poreuse.

Dans cet exemple, la zone poreuse ZP n'est pas localisée.

Dans cet exemple de réalisation, le dispositif D4 comporte un unique bloc de contact 114 ayant une section transversale en forme de cadre rectangulaire et entoure la structure MEMS, le plot traversant la couche active 6, la couche diélectrique 4 est en contact mécanique avec le substrat support 2.

Le dispositif comporte en outre sur sa face avant une tranchée 30 en entourant la structure NEMS et présentant une profondeur et une largeur telles que la réalisation de la tranchée supprime tout contact mécanique entre le bloc de contact 114 et la couche active 6, isolant ainsi électriquement la structure NEMS du bloc de contact 114 et donc la structure NEMS du substrat support 2.

La tranchée 30 présente une largeur plus grande que la largeur du bloc de contact et une profondeur supérieure à l'épaisseur de la couche active.

Cette isolation électrique entre la structure NEMS et le substrat support 2 est intéressante par exemple pour isoler différents NEMS d'un même dispositif ou différentes structures mécaniques d'un même dispositif ou encore différents dispositifs qui seraient réalisés de manière collective sur un même substrat.

Cette tranchée 30 forme une zone d'isolation électrique isolante entre la structure NEMS et le bloc de contact 114.

Cette tranchée peut être laissée vide ou remplie d'un matériau isolant électrique; par exemple identique à celui de la couche isolante 4. Le remplissage de la tranchée permet de conserver une surface plane à la surface du dispositif permettant, par exemple d'ajouter des niveaux d'interconnexions métalliques, de sceller un capot pour refermer la structure, d'hybrider un autre dispositif offrant une fonction supplémentaire, etc... Ce remplissage permet également d'assurer l'isolation entre la couche active et le substrat indépendamment du milieu dans lequel va être placé le dispositif au final, y compris si celui-ci présente des caractéristiques conductrices.

La forme de la tranchée dépend de la forme du bloc de contact. Elle présente une forme et des dimensions telles qu'elle supprime tout contact direct entre la couche active et le bloc de contact. Dans le cas de plusieurs blocs de contact, on pourrait prévoir de réaliser une seule tranchée pour toutes les blocs ou des gravures distinctes afin d'isoler chaque bloc de contact de la couche active 6 ou d'isoler les blocs par groupe.

Dans les exemples représentés, l'isolation électrique entre la structure NEMS et le substrat support 2 est obtenue en supprimant le contact entre le NEMS et le bloc de contact. Il est envisageable de réaliser cette isolation électrique en interrompant le contact entre le substrat support et le bloc de contact, par exemple en faisant une tranchée dans la face arrière.

En variante, il peut être envisagé pour isoler électriquement la structure NEMS et le substrat support 2 d'appliquer un traitement au(x) blocs(s) de contact pour les faire passer d'un état conducteur à un état isolant. Par exemple, dans le cas d'un plot en semi-conducteur, des dopages particuliers par diffusion ou par implantation par exemple, peuvent être réalisés, ceux-ci permettant de bloquer le passage d'un courant, éventuellement moyennant l'application de tensions de polarisations. Des structures de type jonctions PN, diodes, transistors... par exemple seraient ainsi formées.

Le dispositif D4 comporte une partie suspendue 7 dont les extrémités longitudinales présentent une dimension transversale supérieure à une partie centrale de la partie suspendue 7. Ces extrémités de largeur supérieure servent d'ancrages à la partie suspendue de largeur inférieure.

Dans cet exemple, des électrodes 31 sont formées sur la partie fixe de part et d'autre de la partie mobile 7 et en regard des flancs latéraux de la partie suspendue, par exemple pour détecter son déplacement et/ou la mettre en mouvement par des forces électrostatiques. La partie suspendue7 est alors mobile.

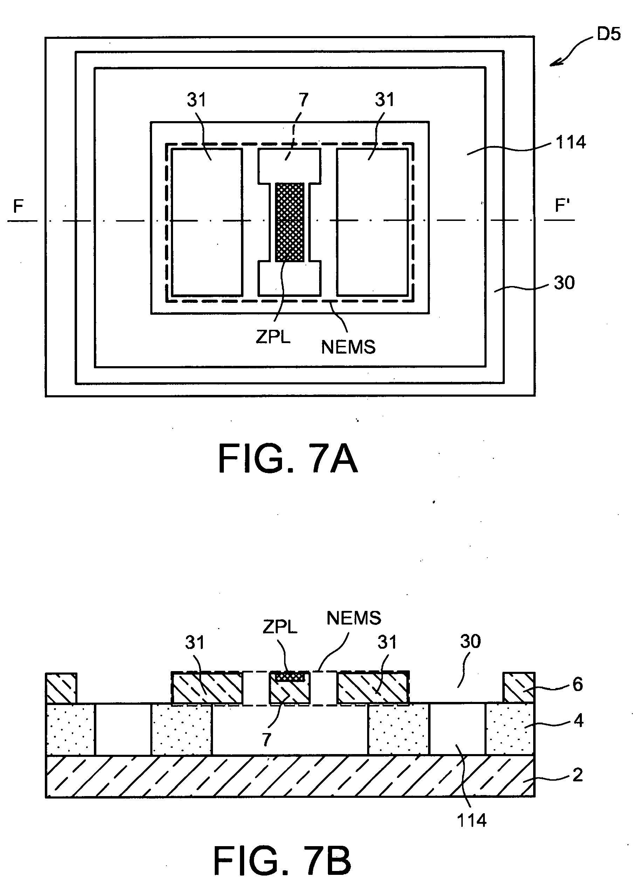

Sur les figures 7A et 7B, on peut voir un autre exemple de réalisation d'un dispositif D5 obtenu grâce à la présente invention, dans lequel le contact entre la structure NEMS et le substrat support 2 est interrompu et qui comporte une zone poreuse ZPL localisée uniquement sur la partie suspendue 7.

Comme pour le dispositif D5, une tranchée entoure la structure NEMS et supprime le contact entre la couche active 6 et le bloc de contact 114.

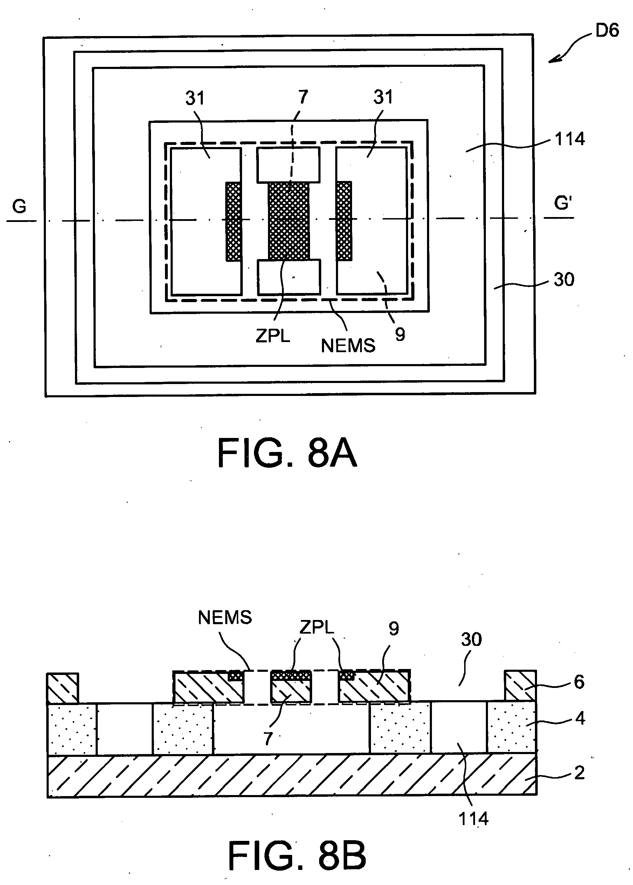

Sur les figures 8A et 8B, on peut voir un autre exemple de réalisation d'un dispositif D6 obtenu grâce à la présente invention, dans lequel le contact entre la structure NEMS et le substrat support 2 est interrompu et qui comporte une zone poreuse ZPL localisée sur une partie de la partie suspendue 7 et sur la partie fixe 9 de part et d'autre de la partie suspendue 7. Comme pour le dispositif D5, une tranchée entoure la structure NEMS et supprime le contact entre la couche active et le bloc de contact 114.

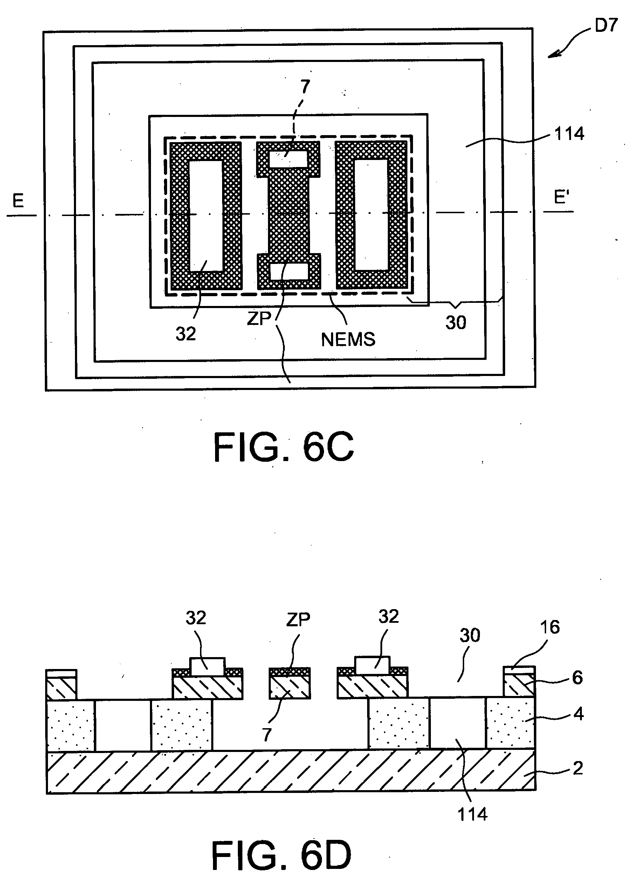

Sur les figures 6C et 6D, on peut voir une variante D7 du dispositif D4, dans laquelle des métallisations 32 sont réalisées sur la partie suspendue 7 et sur la partie fixe 9 afin de permettre une connexion électrique avec l'extérieur par exemple en réalisant des interconnexions métalliques et/ou des plots de contact électriques.

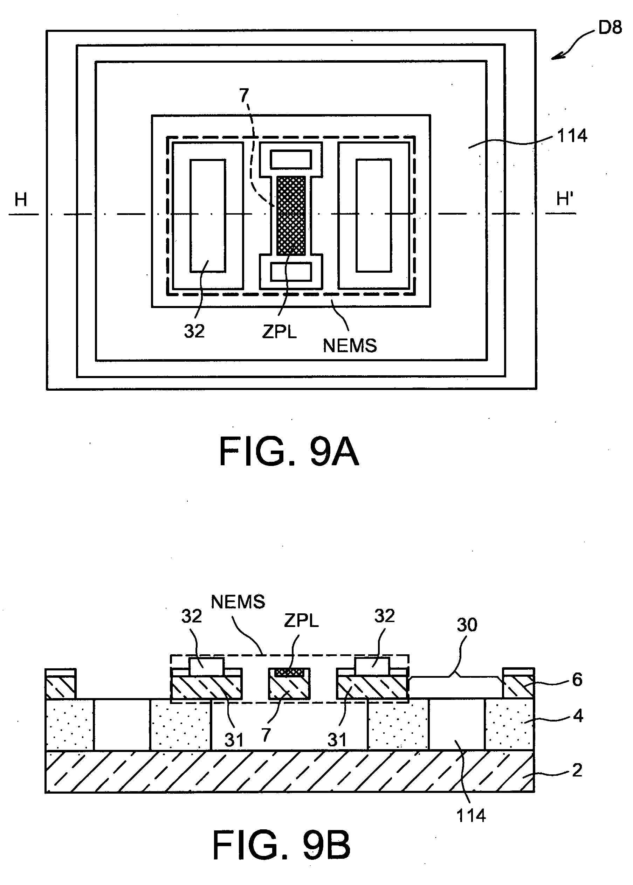

Sur les figures 9A et 9B, on peut voir une variante D8 du dispositif D5, dans laquelle des métallisations 32 sont réalisées sur la partie suspendue 7 et sur la partie fixe 9 afin de permettre une connexion électrique avec l'extérieur par exemple en réalisant des interconnexions métalliques et/ou des plots de contact électriques.

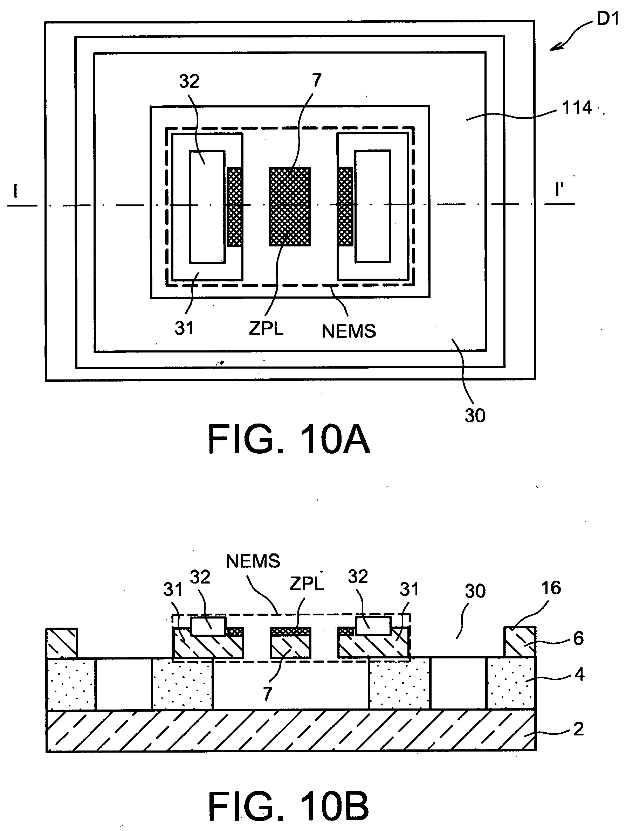

Sur les figures 10A et 10B, on peut voir une variante D9 du dispositif D6, dans laquelle des métallisations 32 sont réalisées sur la partie suspendue 7 et sur la partie fixe 9 afin de permettre une connexion électrique avec l'extérieur par exemple en réalisant des interconnexions métalliques et/ou des plots de contact électriques.

Des exemples de ou des blocs de contact vont être décrits en détail.

Comme cela a été décrit ci-dessus, un ou plusieurs blocs de contacts peuvent être mis en oeuvre pour assurer la circulation du courant entre la face arrière et la face avant de l'empilement.

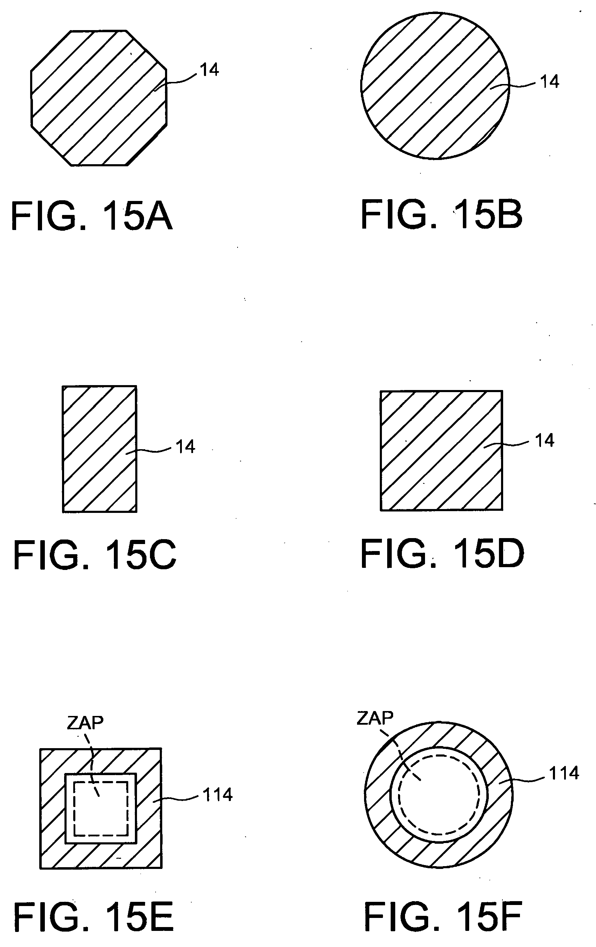

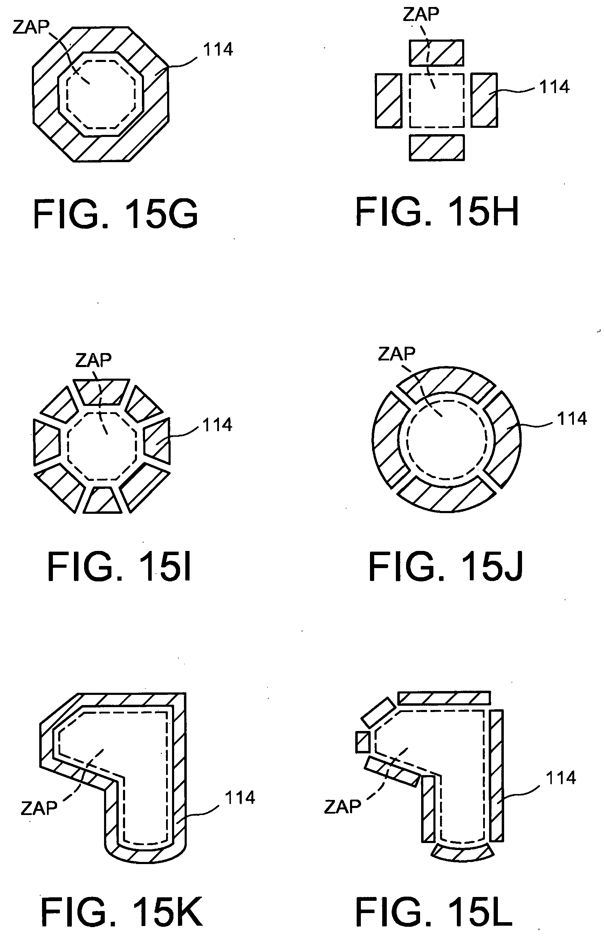

Le bloc ou la pluralité de blocs de contacts peuvent présenter des formes géométriques variées. Sur les figures 15A à 15L, des exemples de blocs de contact 14, 114 vus de dessus sont représentés. Ils peuvent présenter en vue de dessus une forme carrée, rectangulaire, circulaire, polygonale (figures 15A à 15D respectivement) ou quelconque. Leurs dimensions transversales peuvent être de quelques dizaines de nm à plusieurs µm ou dizaines de µm. Les valeurs des dimensions transversales sont choisies en fonction de l'épaisseur de la couche active 6 et de la couche diélectrique 4.

Les plots de contacts 114 peuvent également être en forme de cadre (Figures 15E à 15G). Avantageusement les cadres entourent la zone à porosifier désignée ZAP. Cette forme de cadre présente l'intérêt, en entourant la zone à porosifier d'obtenir des caractéristiques de la zone poreuse uniformes, ces caractéristiques étant par exemple l'épaisseur, la nature du matériau, la dimension et la répartition des pores, etc. Il est à noter que la zone poreuse peut se trouver à l'intérieur et/ou à l'extérieur du ou des cadres. Si la zone à porosifier se situe uniquement à l'intérieur du cadre, un masque est de préférence utilisé pour protéger la zone à l'extérieur du cadre lors de l'étape de porosification.

Sur les figures 15E à 15G, les cadres 114 sont continus autour de la zone à porosifier. Alternativement comme cela est représenté sur les figures 15H à 15J, les cadres peuvent être discontinus.

Par ailleurs, les cadres 114 peuvent présenter une forme quelconque comme cela est représenté sur les figures 15K et 15L, cette forme pouvant être avantageusement adaptée à la forme de la zone à porosifier. De manière préférentielle, la distance entre le bord de la zone à porosifier et le bord du cadre est constante et la largeur du cadre est de préférence également constante, ce qui permet d'assurer des caractéristiques de la zone poreuse uniformes dans la zone à porosifier. Par ailleurs, la forme et la position des blocs de contact tiennent avantageusement compte du procédé d'intégration, en particulier par rapport aux niveaux d'interconnections. Il est à noter qu'en général le phénomène de porosification est mieux contrôlé au centre de la zone délimitée par le ou les blocs de contact que sur le reste de la couche active.

Par exemple, le dispositif D4 représenté sur les figures 6A, et 6B comporte un unique bloc de contact formant un cadre fermé, mais ce bloc de contact pourrait être remplacé par une pluralité de blocs juxtaposés distribués de sorte à former un cadre. Par exemple, le dispositif pourrait comporter quatre blocs de contact de forme parallélépipédique rectangle disposés à angle droit les uns par rapport aux autres de sorte à délimiter un cadre rectangulaire ou alors être formé d'une pluralité de plots de forme carrée, rectangulaire, circulaire, polygonale ou quelconque.

De préférence, les blocs de contact présentent un facteur de forme (rapport hauteur / largeur) raisonnable. La hauteur du bloc, et donc la profondeur de la gravure à réaliser, est la somme de l'épaisseur de la couche 6 et de la couche 4. La largeur du bloc est sa dimension transversale en vue de dessus du dispositif. De préférence la largeur des blocs de contact est de même valeur ou supérieure à leur hauteur, pour permettre de graver facilement le motif et pour faciliter son remplissage, par exemple par épitaxie. Ainsi un facteur de forme de 1 (hauteur du bloc égale à sa largeur) facilite la réalisation technologique, mais selon le type de gravure et/ou de remplissage, des facteurs de forme beaucoup plus élevés (par exemple de l'ordre de 10, c'est-à-dire une profondeur égale à dix fois la largeur) peuvent être envisagés.

Dans un exemple de réalisation, les blocs de contact peuvent être répartis uniquement sur la périphérie de la zone à porosifier, ou bien autour de chaque NEMS à distance de la zone à porosifier ou bien encore au sein même de la zone à porosifier, par exemple dans le cas d'une porosification de toute la face supérieure de l'empilement.

On peut envisager de réaliser plusieurs zones poreuses distinctes, chacune étant réalisée au moyen d'un bloc de contact ou d'un groupe de blocs de contact.

De préférence, les blocs de contact sont réalisés au plus près de la zone à porosifier ce qui permet d'assurer un bon contrôle du procédé et en particulier une bonne homogénéité en épaisseur de la zone poreuse.

De préférence également, la densité de courant qui traverse le bloc ou la pluralité de blocs de contact est répartie de manière homogène par rapport à la zone à porosifier. En effet, la nature du matériau poreux qui va être formé dépend de la densité de courant qui va traverser les blocs de contact lors de la phase de porosification. Cette densité dépend de la conductivité électrique des blocs de contact, par exemple et des dimensions géométriques des motifs, donc entre autres des dopages des matériaux semi-conducteurs intervenant dans la conduction électrique entre la face arrière et la couche à porosifier en face avant, i.e. le matériau de la couche 6, celui du support 2, et celui du plot de contact réalisé entre ces deux couches, de la dimension des blocs de contacts électriques, de la dimension des ouvertures dans le masque de localisation des zones à porosifier qui sera décrit ci-dessous.

Lorsqu'une zone poreuse localisée est réalisée, les blocs de contacts sont avantageusement disposés par rapport à la zone à porosifier à des distances proches, de préférence à égales distances de la zone à porosifier pour assurer une bonne homogénéité de la porosité et de l'épaisseur de la zone porosifiée.

La distance entre le ou les blocs de contact et la zone que l'on désire porosifier est choisie de sorte à éviter que l'épaisseur de matériau poreux formé dans la zone proche du contact ne devienne égale à l'épaisseur de la couche active dans cette zone avant que l'on ait formé le matériau poreux dans la zone souhaitée. En effet, ceci conduirait à bloquer la circulation des porteurs vers la surface à porosifier. Par exemple, pour une épaisseur de couche active 6 de 200 nm, les blocs de contacts peuvent être placés à une distance avantageusement inférieure à quelques mm des zones à porosifier, et de manière préférée à une distance comprise entre quelques dizaines de µm et quelques centaines de µm.

Dans le cas de couches actives présentant une épaisseur de quelques µm à quelques dizaines de µm, par exemple dans des structures MEMS, la distance entre les blocs de contact et la zone à porosifier peut être de l'ordre du centimètre.

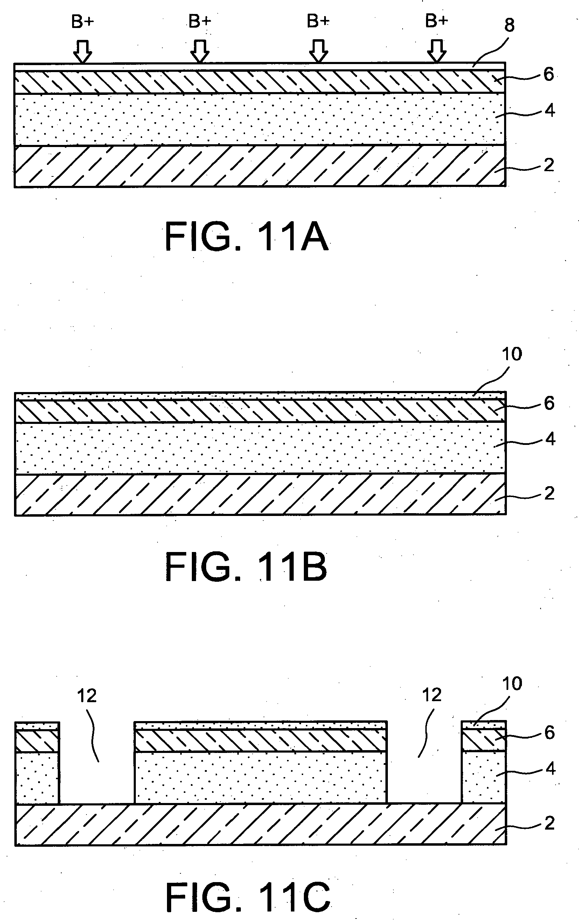

Sur les figures 11A à 11O" sont représentées schématiquement différentes étapes d'un exemple de procédé de réalisation. Cet exemple de procédé permet de réaliser une structure mécanique comportant une partie suspendue.

Dans cet exemple, on part d'un substrat SOI comportant une couche support 2 formant la face arrière, une couche de matériau diélectrique 4 et une couche de silicium 6 formant la face avant. Par exemple la couche 6 présente une épaisseur comprise entre 10 nm et 500 nm, voire plusieurs µm ou même plusieurs dizaines de µm. La couche diélectrique 4 est par exemple une couche BOX (Buried oxyde) dont l'épaisseur est par exemple comprise entre 10 nm et 500 nm, voire plusieurs µm. La couche support, appelée également "bulk", est par exemple en silicium.

Une étape d'implantation de la couche 6 peut avoir lieu, l'implantation peut être soit pleine plaque, soit localisée pour réaliser des dopages préférentiels dans certaines zones, de préférence à travers une couche de protection 8, par exemple en oxyde de silicium dont l'épaisseur est par exemple de l'ordre de 10 nm, formée préalablement. Par exemple un dopage au Bore avec une concentration en dopant de l'ordre de quelques 10¹⁸ atomes/cm³ à " quelques 10¹⁹ atomes/cm³ au niveau de la structure mécanique ou encore plus élevée au niveau des zones qui serviront ensuite à reprendre des contacts électriques. L'étape d'implantation est symbolisée par les flèches B+.

De préférence, après l'étape d'implantation, des recuits à des températures comprises entre 800°C à 1100°C sont réalisés.

La couche 8 peut être ensuite retirée.

Le dopage peut être de type P ou N avec différents niveaux de dopage. Préférentiellement pour un dopage P+, on utilise comme dopant le Bore ou le Gallium à une concentration comprise entre environ 10¹⁸ at/cm³ et environ 10¹⁹ at/cm³; pour un dopage N+, on peut utiliser comme dopant du Phoshore ou de l'Arsenic à une concentration comprise entre environ 10¹⁸ at/cm³ et environ 10¹⁹ at/cm³.

En variante, dans le cas où l'on souhaite réaliser un dopage faible, on peut utiliser des techniques d'illumination de la face arrière du substrat, pour générer des porteurs lors de l'étape de porosification.

La couche support 2 peut être en semi-conducteurs de type N ou de type P.

L'élément ainsi obtenu est représenté sur la figure 11A.

Lors d'une étape suivante, on forme une couche 10 formant un masque dur sur la couche active 6 en vue de la réalisation de contacts électriques entre la couche active 6 et la face arrière 2. Ce masque dur est par exemple un matériau diélectrique, par exemple un oxyde de silicium de quelques microns d'épaisseur.

De manière avantageuse, on peut prévoir que la couche 8 d'oxyde utilisée pour l'implantation serve de masque dur, ce qui évite avantageusement de retirer la couche 8 et de déposer une nouvelle couche pour former le masque.

En réalisant le masque dur 10 en oxyde de silicium alors que le substrat support est en silicium, il est alors possible de réaliser les blocs de contact par épitaxie sélective lors de l'étape de remplissage des blocs de contacts comme cela sera décrit en détail ci-dessous. La couche 10 pourrait alternativement être réalisée en nitrure de silicium SiN, ou encore en nitrure de Titane TiN...

L'élément ainsi obtenu est représenté sur la figure 11B.

Lors d'une étape suivante, on réalise au moins une gravure 12 dans l'élément de la figure 11B à partir de la face avant, qui atteint la couche support 2. Un bloc de contact sera formé dans cette gravure.

La forme, le nombre et la disposition des gravures seront décrits dans la suite de la description.

On réalise par exemple une photolithographie sur la couche 10 pour délimiter des zones à graver.

On réalise ensuite des gravures successives de préférence anisotropes, par exemple des gravures sèches telles que la gravure par ions réactifs (RIE pour "Reactive-Ion Etching" en terminologie anglo-saxonne) du masque dur 10, de la couche active 6 et de la couche 4, jusqu'à atteindre la couche support 2.

Lors d'une étape suivante, la résine déposée sur le masque dur pour la photolithographie est retirée.

L'élément ainsi obtenu est représenté sur la figure 11C.

Lors d'une étape suivante, on forme les blocs de contacts 14 dans les gravures 12.

De préférence, les blocs de contact 14 sont réalisés par épitaxie de Si de façon à ce que le matériau épitaxié réalise le contact électrique entre la couche support 2 et la couche 6. Le silicium est de préférence de la même nature que celui de la zone active. De préférence, l'épitaxie est réalisée de manière à obtenir une légère surépaisseur au dessus du masque dur 10, ce qui permet d'assurer un remplissage complet des gravures.

L'épitaxie est préférentiellement une épitaxie sélective, elle permet de remplir les gravures 12 sans épaissir la couche de silicium 6 dans laquelle sera réalisée la structure NEMS par la suite. La mise en oeuvre d'une épitaxie non sélective est envisageable. On prévoit alors une étape de planarisation de la couche 6 afin d'obtenir une face plane, par exemple par un procédé de polissage mécano-chimique ou CMP (Chemical Mechanical Planarisation, en anglais). On pourra dans ce cas-là utiliser le masque dur en oxyde pour arrêter cette étape sans toucher à la surface de la couche 6.

En variante, les blocs de contacts 14 peuvent être réalisés en un autre matériau que celui de la couche 6. Ils peuvent être réalisés dans tous matériaux conducteurs, par exemple des métaux ou des semi-conducteurs. Les blocs de contact pourraient également être réalisés en polysilicium par dépôt par exemple.

De plus, les blocs de contact peuvent être réalisés par d'autres techniques, telles que le dépôt chimique en phase vapeur ou CVD (Chemical Vapor Deposition en terminologie anglo-saxonne), par dépôt physique en phase vapeur ou PVD (Physical Vapor Deposition en terminologie anglo-saxonne) par évaporation, par pulvérisation...

En alternative, il peut être envisagé de réaliser les blocs de contact par formation de plusieurs couches de matériau conducteurs dans les gravures. La partie remplie peut ainsi comporter plusieurs couches offrant une conductivité électrique suffisante.

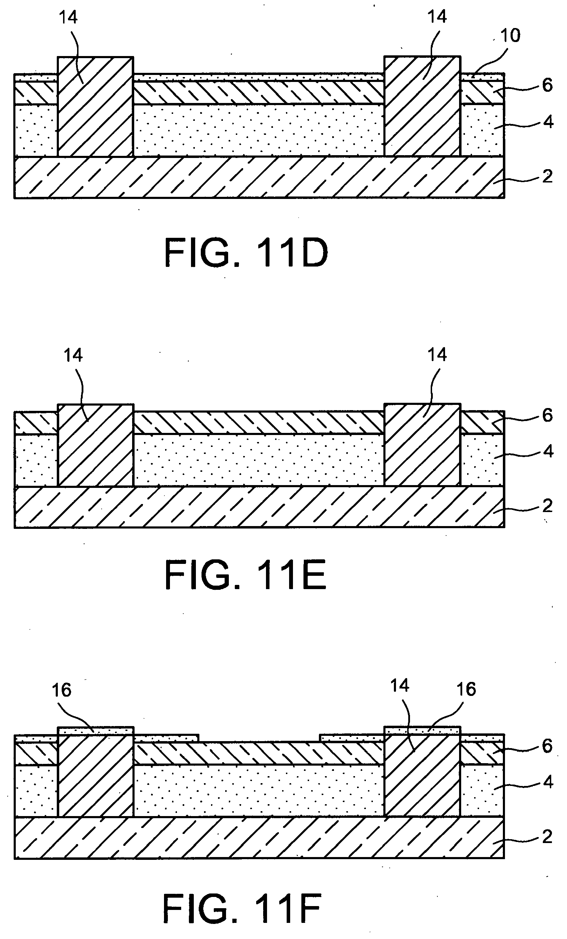

L'élément ainsi obtenu est représenté sur la figure 11D.

Lors d'une étape suivante, on réalise une planarisation des blocs de contact 14 par exemple par polissage mécano-chimique avec arrêt sur le masque dur, et le masque dur 10 est ensuite retiré par exemple par gravure isotrope. En variante, la planarisation des blocs de contact peut avoir lieu après le retrait du masque dur.

L'élément ainsi obtenu est représenté sur la figure 11E.

Lors d'une étape suivant, on délimite la ou les zones de la face avant 6 que l'on souhaite rendre poreuse(s).

Pour cela on forme un masque 16 sur la face avant qui va localiser le traitement de porosification du silicium.

Le masque est par exemple en Nitrure de Silicium formé par exemple par dépôt chimique en phase vapeur assisté par plasma (ou PECVD, pour Plasma-Enhanced Chemical Vapor Deposition en terminologie anglo-saxonne) de préférence à une température de 350°C. Cette température permet de ne pas impacter les dopages réalisés précédemment.

Lors d'une étape suivante, on ouvre le masque de localisation 16 afin de rendre accessible les zones de la face avant 6 à porosifier. L'ouverture du masque de localisation 16 est par exemple réalisée par photolithogravure.

L'épaisseur du masque 16 est choisie en fonction de la profondeur selon laquelle on souhaite porosifier la couche 6. Par exemple, le masque 16 a une épaisseur de quelques centaines de nm pour obtenir une porosification sur une profondeur de quelques centaines de nm.

En variante, le masque de localisation peut être réalisé en oxyde de silicium déposé présentant une bonne sélectivité par rapport au silicium, lors du retrait du masque. Il peut s'agir par exemple d'un oxyde TEOS (de tetraethylorthosilicate) formé à 400°C.

L'élément ainsi obtenu est représenté sur la figure 11F.

Lors d'une étape suivante, on réalise la porosification de la zone de La couche 6 délimitée par le masque 16.

Cette étape de porosification est réalisée par voie électrochimique en imposant la circulation d'un courant électrique entre la couche 6 et la couche support 2, les mouvements de porteurs du courant étant rendus possibles entre les deux couches par la présence du ou des bloc(s) de contact.

La porosification par voie électrochimique est réalisée en disposant l'élément de la figure 11F dans un bain permettant l'électro-porosification du wafer de silicium. Le silicium joue le rôle d'anode et est immergé par exemple dans une solution d'acide hydrofluorique sous un courant électrique déterminé. Il est bien connu de l'homme du métier que le silicium poreux peut être obtenu par voie électrochimique ou photo-électrochimique, et plus précisément par dissolution anodique en milieu acide fluorhydrique, à partir d'une couche de silicium. Dans ce cadre, l'échantillon de silicium à porosifier est immergé dans un milieu d'acide fluorhydrique de concentration pouvant typiquement varier de 1% à 50% selon plusieurs types de configuration (ci-dessous).

La technique de porosification par voie électrochimique est par exemple décrite dans le document Silicon Porosification : State of the Art, G Kototcenkov & BK Cho, in Critical Reviews in Solid State and Materials Sciences 35:153-260, 2010*.*

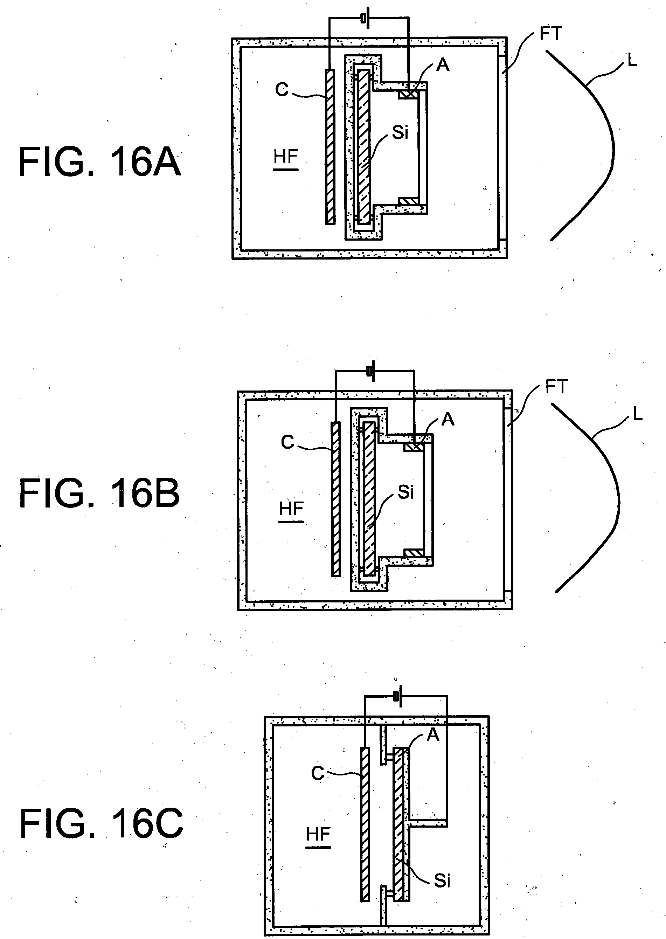

Sur les figures 16A à 16C, on peut voir différents installations de porosification par voie électrochimique.

L'installation comporte une enceinte dans laquelle à lieu la réaction électrochimique, A désigne l'anode, C désigne la cathode le substrat est désigné par Si. La solution d'acide fluorhydrique est désignée HF.

Les installations des figures 16A et 16B permettent une porosification par voie photo-électrochimique. Pour cela, elles comportent une enceinte munie d'une fenêtre FT en regard de laquelle est disposée la face arrière du substrat. Une lampe L est disposée en face de la fenêtre à l'extérieur de l'enceinte et illumine la face arrière du substrat. Sur la figure 16A, le substrat est complètement immergé dans la solution d'acide fluorhydrique.

Sur la figure 16B, le substrat est immergé dans la solution d'acide fluorhydrique en face avant et dans un type de solution liquide en face arrière, par exemple du K₂SO₄.

Sur la figure 16C, le contact électrique est pris directement en face arrière du substrat Si à porosifier, seule la face avant est en contact avec la solution HF.

En fonction des conditions de porosification, telles que la nature de la solution électrolytique, la quantité de courant, le niveau de tension, l'illumination,... et de la nature du substrat, par exemple son type P, N, des conditions de dopage..., le silicium poreux peut être classé suivant trois catégories en fonction du diamètre des pores : microporeux (diamètre des pores < 2nm), mésoporeux (2 nm < diamètre des pores < 50 nm) ou macrométriques (diamètre des pores > 50 nm).

Pour des substrats de type p⁺ par exemple, dont la résistivité de la plaque de silicium est de l'ordre de quelques dizaines de mOhms.cm, le silicium poreux peut être directement obtenu par anodisation du substrat dans l'acide fluorhydrique.

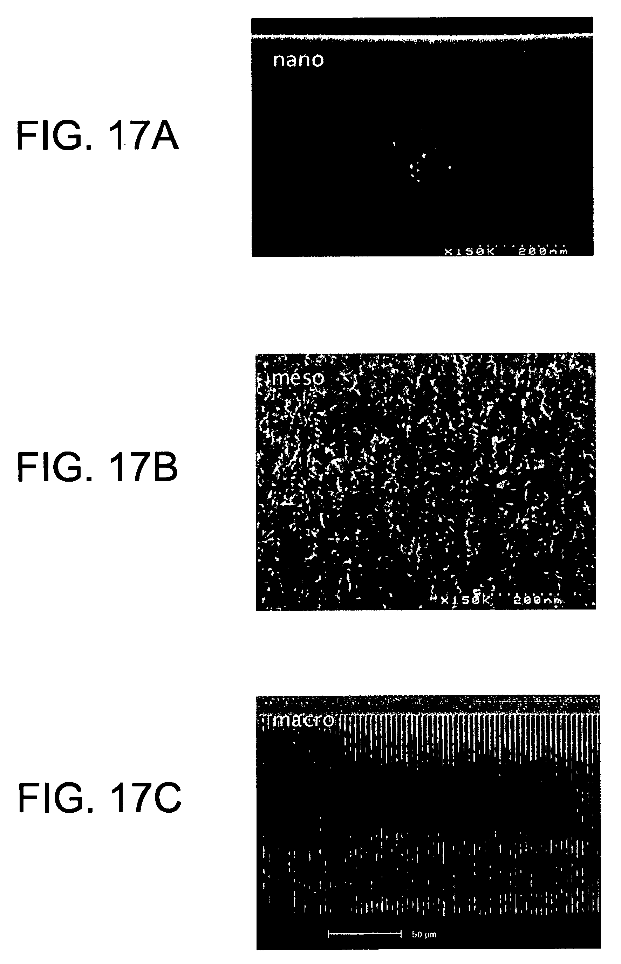

La photo de la figure 17A représente un silicium microporeux, La photo de la figure 17B représente un silicium mésoporeux, et la photo de la figure 17C représente un silicium macroporeux. La photo de la figure 17B représente typiquement le type de porosité obtenu dans un milieu HF 15%. La densité de courant utilisé pour porosifier un tel matériau pourra varier de quelques mA/cm² à plusieurs A/cm². En faisant varier ces types de paramètre, par exemple la concentration HF, la densité de courant, le type de substrat, il est possible de faire varier le diamètre des pores ainsi que le taux de porosité. Ce taux pouvant varier de 4% à 97%.

Les techniques pour obtenir des caractéristiques morphologiques données du silicium poreux (tailles de pores, taux de porosité et épaisseur) en faisant varier les conditions procédés utilisées (concentration HF, densité de courant, illumination, substrat Silicium), sont bien connues de l'homme du métier et ne seront pas décrites en détail. Des techniques de réalisation de silicium poreux sont décrites par exemple dans *"*Formation and Application of Porous Silicon" J. Föll, M. Christophersen, J. Carstensen, G. Hasse, Materials Science and Engineering R280 (2002) 1-49*.*

L'épaisseur de la couche poreuse est principalement fonction du temps d'anodisation. Il est ainsi possible d'obtenir des couches de quelques nanomètres à plusieurs centaines de micromètres.

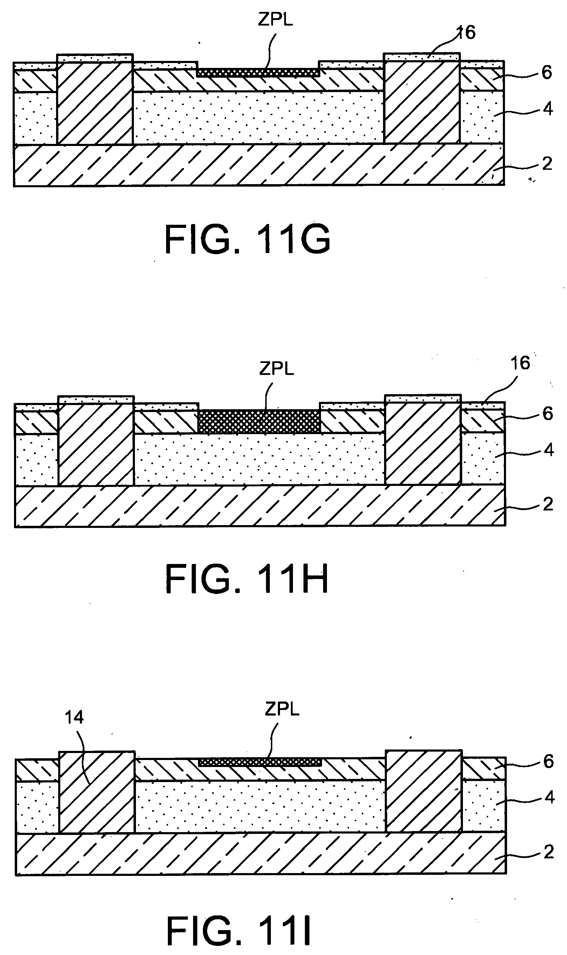

La profondeur de porosification peut correspondre à une partie de l'épaisseur de la couche 6 (figure 11G) ou alors être égale à l'épaisseur de la couche 6 (figure 11H). La zone rendue poreuse est localisée et est désignée ZPL.

Lors d'une étape suivante, le masque de localisation 16 est retiré, le retrait est sélectif par rapport au silicium poreux et par rapport au silicium de la couche 6. Le retrait est réalisé par exemple par gravure isotrope.

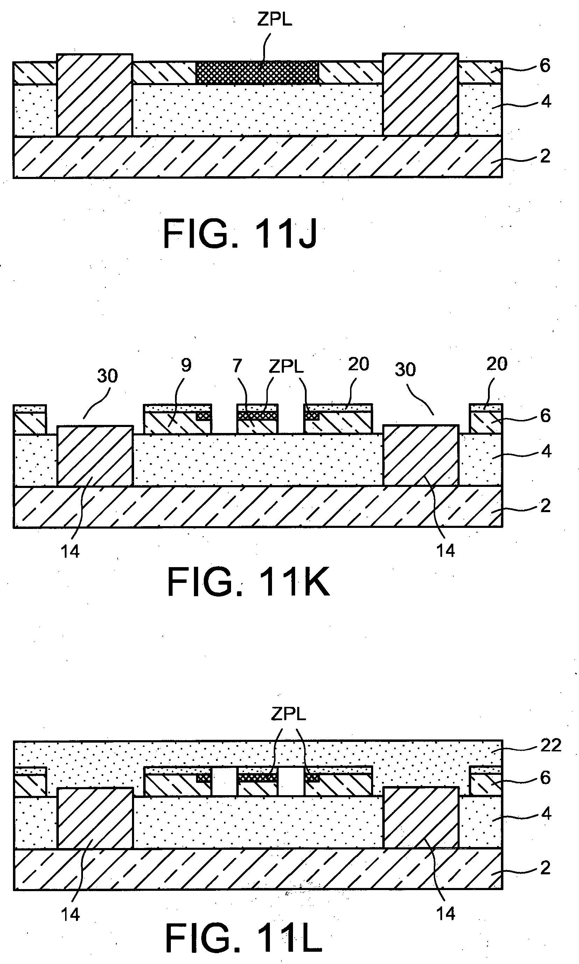

L'élément ainsi obtenu est représenté sur la figure 11I obtenu à partir de l'élément de la figure 11G et sur la figure 11J obtenu à partir de l'élément de la figure 11H.

Cette étape de retrait du masque de localisation pourrait être effectuée ultérieurement, par exemple lors de la réalisation de la structure NEMS ou après la réalisation de la structure NEMS.

Lors d'une étape suivante, on forme la structure NEMS.

Pour cela, on forme un masque 20 sur la face avant de l'élément de la figure 11I, i.e. sur la zone poreuse ZPL et les portions de couche 6 encore existantes. Ce masque protège la zone poreuse ZPL pour éviter d'altérer ses propriétés lors des étapes ultérieures ainsi que les portions de la couche 6 qui ne doivent pas être gravées. Ce masque est par exemple un oxyde de silicium, par exemple à base de silane, ou un nitrure de silicium. De préférence la formation de ce masque s'effectue à basse température, afin de ne pas modifier les propriétés de porosité du silicium poreux. Cette température est de préférence inférieure à 450°C.

Lors d'une étape suivante, on définit les contours de la structure NEMS, i.e. les contours de la partie suspendue et de la partie fixe. Cette définition est réalisée par exemple par photolithographie sur le masque 20.

Dans l'exemple représenté, des motifs de photolithographie sont également réalisés sur le masque 20 pour permettre la gravure de la tranchée d'isolation 30 dans la couche active 6 au voisinage des blocs de contact 14 de sorte à isoler électriquement la structure NEMS réalisée dans la couche active 6 par rapport aux blocs de contact 14.

A lieu ensuite une étape de gravure du masque dur 20, de la couche 6 et de la zone poreuse ZPL pour former la structure NEMS et de gravure de la tranchée d'isolation pour isoler électriquement le NEMS des blocs de contact.

De préférence, la gravure est une gravure anisotrope, par exemple du type RIE à base de SF₆ pour la gravure du silicium.

Dans l'exemple représenté, la gravure se fait avantageusement dans la zone poreuse. De cette manière, on obtient un recouvrement maximal en matériau poreux de la partie suspendue tout en évitant d'avoir à aligner précisément la zone poreuse par rapport à la partie suspendue, ce qui peut être relativement complexe dans le cas de largeurs de structure mécanique et/ou de tranchées bordant cette structure de faible largeur, par exemple comprises entre quelques dizaines de nm et quelques centaines de nm.

Il résulte de cette gravure dans la zone poreuse que la partie fixe comporte des portions poreuses au niveau de ses bords latéraux orientés vers la partie suspendue. Ainsi on est assuré que toute la partie suspendue 7 est recouverte d'une couche poreuse.

En variante, comme cela sera décrit ci-dessous, la définition du NEMS peut ne pas impliquer la gravure de la zone poreuse, par exemple dans le cas où la zone poreuse ne formerait qu'une partie seulement de la partie suspendue du NEMS.

Lors d'une étape suivante, le masque dur 20 peut éventuellement être retiré. Néanmoins dans le cas où le procédé se poursuit par un nouveau dépôt d'oxyde, par exemple pour la réalisation d'interconnexions métalliques, le masque dur peut être conservé, comme c'est le cas dans l'exemple décrit.

Dans l'exemple décrit et de manière avantageuse le NEMS et la tranchée d'isolation 30 sont gravés simultanément. En variante, le NEMS et la tranchée d'isolation 30 pourraient être gravées successivement, le NEMS en premier et la tranchée d'isolation en deuxième ou inversement.

L'élément ainsi obtenu est représenté sur la figure 11K.

Lors d'une étape suivante, on réalise des interconnexions métalliques.

Pour cela on forme en face avant de l'élément de figure 11K une couche en matériau diélectrique 22, par exemple un oxyde de silicium. Cette couche 22 permet de créer une surface isolante et de planariser la surface de l'élément.

De manière également avantageuse, dans le cas où une étape de gravure a lieu ultérieurement pour libérer la partie suspendue, le matériau de la couche 22 est choisi pour ne pas laisser de résidus lors d'une gravure à l'acide fluorhydrique vapeur. Le matériau de la couche 22 est par exemple un oxyde de silicium de type SiH₄ 400°C.

L'épaisseur de la couche 22 est choisie suffisante pour réduire la topologie du NEMS et assurer une isolation électrique suffisante au dessus de la couche 6 afin de permettre la réalisation de lignes d'interconnexions et de plots métalliques. L'épaisseur de la couche 22 est par exemple de l'ordre du µm pour une épaisseur de silicium de la couche 6 de 200nm.

De préférence, une étape de polissage de la couche 22 a lieu, par exemple par polissage mécanochimique, pour planariser la surface.

Des étapes de gravures avec des contre-masques intermédiaires bien connues dans l'homme du métier peuvent avantageusement être réalisées pour faciliter l'étape de CMP.

L'élément ainsi obtenu est représenté sur la figure 11L.

Lors d'une étape suivante, on délimite les zones dans la couche 22 dans lesquelles seront formées les interconnexions et/ou des plots de contact destinés par exemple à des liaisons par wire-bonding avec l'extérieur.

Pour cela, on réalise une lithographie sur la couche 22.

La couche 22, éventuellement le masque dur s'il est encore présent, puis le silicium poreux s'il est présent dans les zones gravées 24, ce qui n'est pas le cas sur la figure 11L, sont gravés au niveau des zones délimitées par lithographie pour atteindre la couche 6. Dans l'exemple représenté, les gravures 24 sont formées au droit de la partie fixe 9.

La résine est ensuite retirée sur la couche 22.

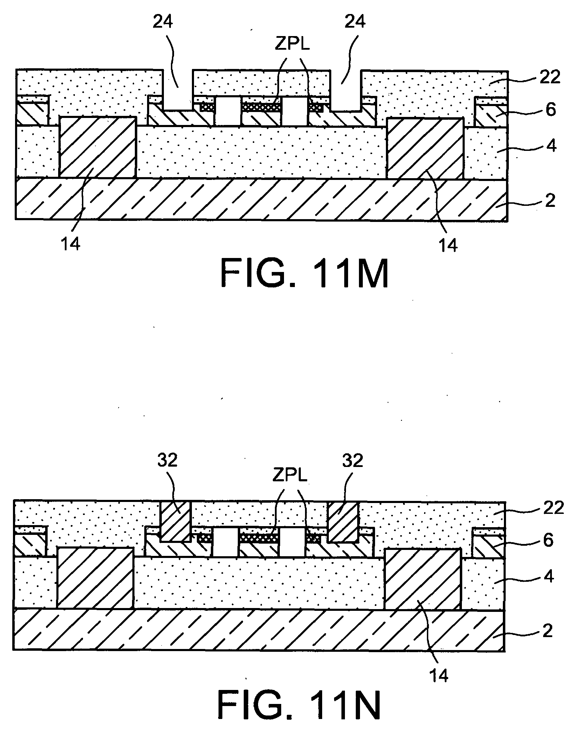

L'élément ainsi obtenu est représenté sur la figure 11M.

Lors d'une étape suivante, on réalise les interconnexions et/ou les plots de contact.

Pour cela, on effectue un dépôt d'un matériau conducteur dans les zones gravées 24 pour former des contacts électriques 32.

De préférence, le matériau conducteur est choisi de sorte à résister à la gravure de la couche isolante 4 lors de la libération de la structure mécanique. Le matériau conducteur choisi est par exemple de l'AISi capable de résister à la gravure à l'acide fluorhydrique vapeur utilisé pour graver localement le BOX formant la couche 4 afin de libérer la structure mécanique. En variante, il peut s'agir d'AlCu. Dans le cas où il n'y a pas de libération ultérieure d'une structure mécanique, le matériau conducteur peut être choisi parmi les matériaux choisis classiquement en micro et nanoélectronique.

Dans le cas d'un unique niveau métallique, l'AISi est déposé sur toute la surface, donc dans les zones gravées 24 mais aussi à la surface de la couche isolante 22. On poursuit alors par une étape de polissage mécanochimique pour ne garder de l'AlSi que dans les motifs 32 ou alors par une photolithographie et une gravure de la couche AlSi sur la surface 22 qui permet de définir les zones de contact électrique (contacts AlSi avec la couche 6, représentés sur les figures 11M et 11N), des plots de contacts électriques à la surface de la couche 22 ces plots pouvant être utilisés par exemple pour du wire bonding, et des lignes d'interconnexions électriques permettant de relier les deux. Pour des raisons de clarté, seules les zones de contact AlSi/couche 6 sont schématisées sur les figures.

Dans le cas ou plusieurs niveaux métalliques sont nécessaires, par exemple pour des réseaux de NEMS, des étapes de polissage, par exemple mécano-chimique, des couches de matériau conducteur déposées peuvent être introduites dans le procédé avec arrêt sur oxyde. Ces étapes permettent de conserver la planéité de la surface au cours du procédé. Ces étapes participent également à l'isolation des couches entre elles. Ces étapes sont connues par ailleurs pour réaliser des interconnexions à plusieurs niveaux métalliques.

L'élément ainsi obtenu est représenté sur la figure 11N.

Lors d'une étape suivante, on libère la structure NEMS.

On retire les couches 20 et 22, par exemple par gravure, au moins dans la zone de la structure à libérer afin d'accéder aux ouvertures dans la couche 6 et ensuite à la couche sacrificielle 4.

Ensuite on effectue une gravure isotrope, par exemple par acide fluorhydrique vapeur de la couche sacrificielle permettant de libérer la structure mécanique qui se retrouve alors partiellement suspendue.

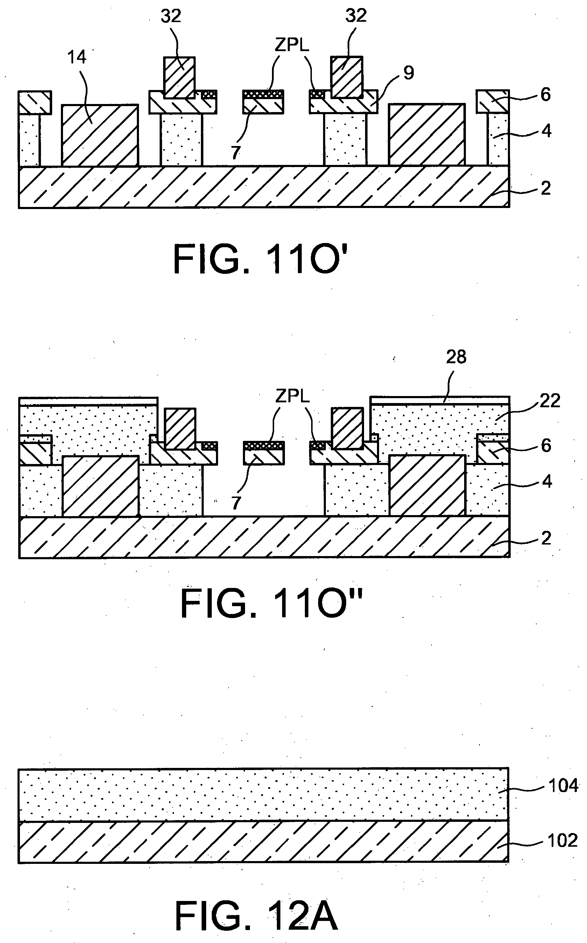

L'élément ainsi obtenu est représenté sur la figure 11O'. Dans cette représentation, les couches 20 et 22 étant gravées au niveau de la structure mécanique et également autour des blocs de contact. Sur la figue 110", en revanche afin de conserver la couche sacrificielle autour des blocs de contact, on peut utiliser une couche de protection localisée 28 permettant de n'ouvrir les couches 20 et 22 qu'au niveau de la structure mécanique à libérer. La couche de protection localisée 28 est par exemple en silicium formé sur la couche 22, qui est structurée par lithographie et gravure avant l'étape de libération.

Grâce à l'exemple de procédé décrit ci-dessus, on peut réaliser une structure NEMS avec une partie suspendue comprenant au moins une partie poreuse par voie électrochimique et ainsi profiter des avantages de cette technique de porosification, i.e. un bon contrôle des vitesses de formation du matériau poreux, des taux de porosité, des diamètres des pores, des orientations particulières des pores, etc.

Nous allons maintenant décrire un autre exemple de procédé de réalisation d'une zone poreuse selon la présente invention, dont une partie des étapes est schématisée sur les figures 12A à 12D.

Dans cet exemple, le substrat de départ ne comporte pas la couche conductrice active.

On utilise un substrat support 102 conducteur ou semi-conducteur sur lequel on forme une couche en matériau isolant 104, par exemple en oxyde de silicium, dont l'épaisseur est comprise par exemple entre quelques dizaines de nm à plusieurs dizaines de µm. Cette couche sera utilisée ultérieurement pour libérer la structure mécanique.

L'élément ainsi obtenu est représenté sur la figure 12A.

Lors d'une étape suivante, la couche isolante 104 est structurée de sorte à réaliser les trous ou tranchées 112 pour recevoir les blocs des contacts. La structuration est réalisée par exemple par photolithogravure de sorte à ouvrir la couche 104. Le fond des trous ou tranchées est formé par le substrat support 102.

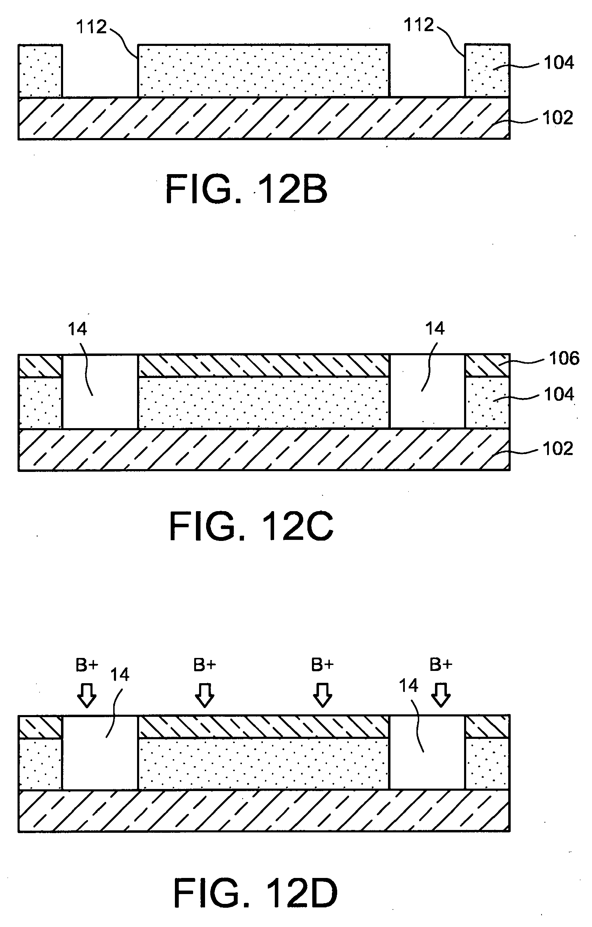

- L'élément ainsi obtenu est représenté sur la figure 12B.

Lors d'une étape suivante, on forme à la fois les blocs de contact 14 et la couche active 106, par exemple par épitaxie non sélective, par exemple de Si de façon à ce que le matériau épitaxié réalise le contact électrique entre le substrat support 102 et la couche active 106. En variante, deux étapes séparées pourraient être mises en oeuvre : une étape pour réaliser les contacts, une autre étape pour réaliser la couche active.

De préférence, une planarisation de la couche active 106 a ensuite lieu, par exemple par CMP.

Il est à noter qu'après épitaxie sur le substrat support 102 et la couche isolante 104, le silicium des blocs de contact est monocristallin dans le cas ou le support 2 est lui-même monocristallin et le silicium de la couche active 106 au dessus de la couche isolante 104, ici en oxyde de silicium, est de type polycristallin. La structure NEMS qui sera réalisée dans la couche active 106 sera alors en silicium polycristallin dans ce cas-là.

D'autres matériaux conducteurs électriques pour former les blocs de contact et la couche active peuvent être envisagés, tels que les métaux par exemple. En outre, ils peuvent être déposés par d'autres techniques également, par CVD, PVD, évaporation, pulvérisation, etc.

Comme pour le procédé des figures 11A à 11O", les blocs de contact peuvent être réalisées en plusieurs couches offrant une conduction suffisante.

Dans l'exemple décrit ci-dessus, la couche active 106 est réalisée simultanément aux blocs de contact 14 par épitaxie. En variante, elle peut être réalisée par dépôt. Il peut être envisagé de la réaliser suivant une technique différente de celle utilisée pour former les blocs de contact, par exemple par des techniques de report de couches ou de substrat. Les blocs de contact et la couche active peuvent être réalisés dans des matériaux différents.

L'élément ainsi obtenu est représenté sur la figure 12C.

Lors d'une étape suivante et comme cela est schématisé sur la figure 12D, la couche active 106 peut avantageusement être dopée de manière similaire à l'étape de la figure 11A. Les détails de cette étape ne seront pas répétés.

L'élément obtenu diffère de celui de la figure 11E, en ce que les blocs de contact ne sont pas en saillie de la couche active 106.

Les étapes suivantes pour réaliser un dispositif tels que ceux des figures 2A à 10B sont similaires aux étapes des figures 11F à 11O" et ne seront pas répétées.

Une zone poreuse localisée ou non localisée peut être réalisée dans tout ou partie de la couche active.

Il peut alors subir les mêmes étapes pour réaliser la structure NEMS.

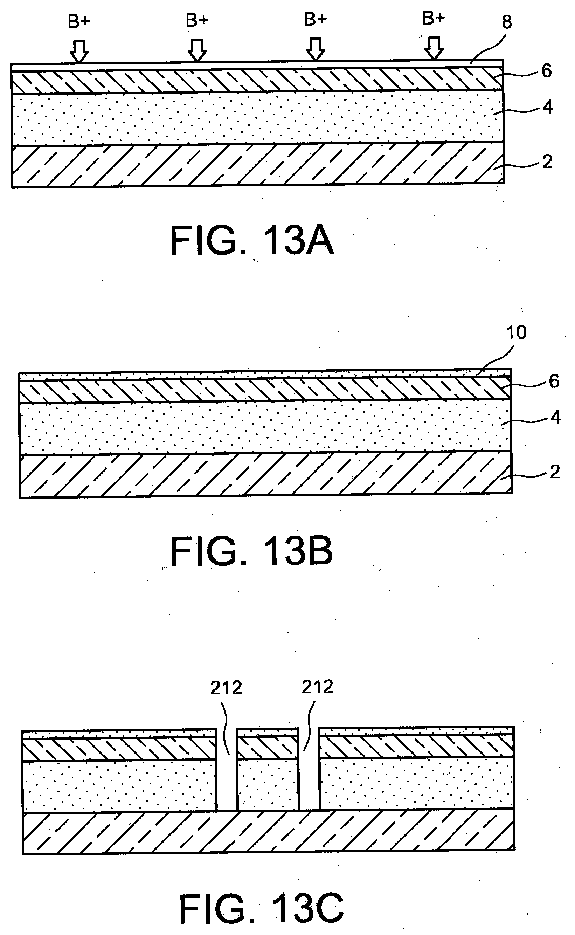

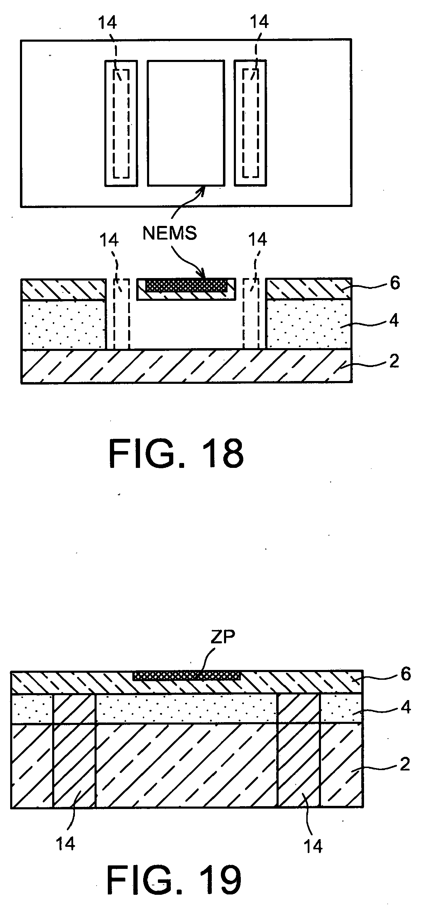

Nous allons maintenant décrire un autre exemple de procédé de réalisation selon l'invention dans lequel les blocs de contact électriques entre la couche active 6 et la couche support 2 ne sont pas conservés, dont une partie des étapes est schématisée sur les figures 13A à 13L. Dans ce procédé, les blocs de contact sont formés dans les zones qui sont destinées à être gravées ensuite pour définir la structure NEMS et non sur le pourtour des structures NEMS, comme le montre la figure 18. Les blocs de contact 14 sont représentés en pointillés. Ce procédé offre un gain en encombrement. Par ailleurs, les blocs de contact sont éliminés, au moins en partie, lors de l'étape de gravure de la couche 6 qui permet de définir la structure NEMS, il en résulte donc un gain de temps. Ce procédé peut s'appliquer si l'on part d'un substrat SOI ou si l'on part d'un substrat ne comportant pas au départ de couche active comme cela a été décrit en relation avec les figures 12A à 12D.

Dans l'exemple qui décrit dans la suite, comme pour le procédé des figures 11A à 11O", le substrat de départ est un substrat SOI.

Les étapes représentées sur les figures 13A et 13B sont similaires à celles du procédé des figures 11A et 11B et ne seront pas décrites à nouveau.

Lors d'une étape suivante, l'empilement est gravé pour former les trous 212 pour les blocs de contact. Les étapes de réalisation sont similaires à celles décrites en relation avec la figure 11C. Dans cette exemple, les trous sont réalisés au plus proche de la zone à porosifier et, plus particulièrement dans la ou les zones destinées à être gravées pour former la structure NEMS et éventuellement la libérer.

L'élément ainsi obtenu est représenté sur la figure 13C.

Lors d'une étape suivante, on réalise les blocs de contact 214 de manière similaire aux étapes de procédé décrites en relation avec les figures 11D et 11E, de préférence par épitaxie sélective.

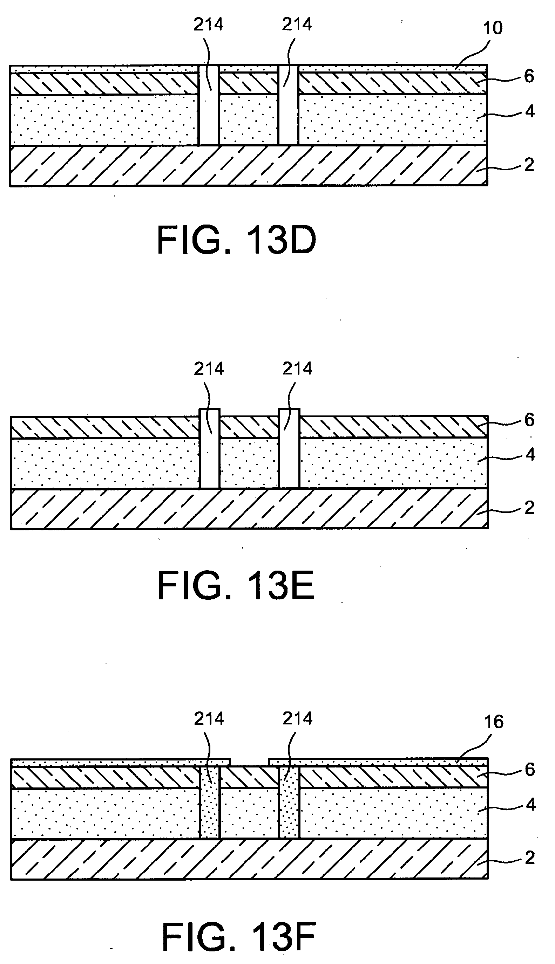

L'élément ainsi obtenu est représenté sur la figure 13D.

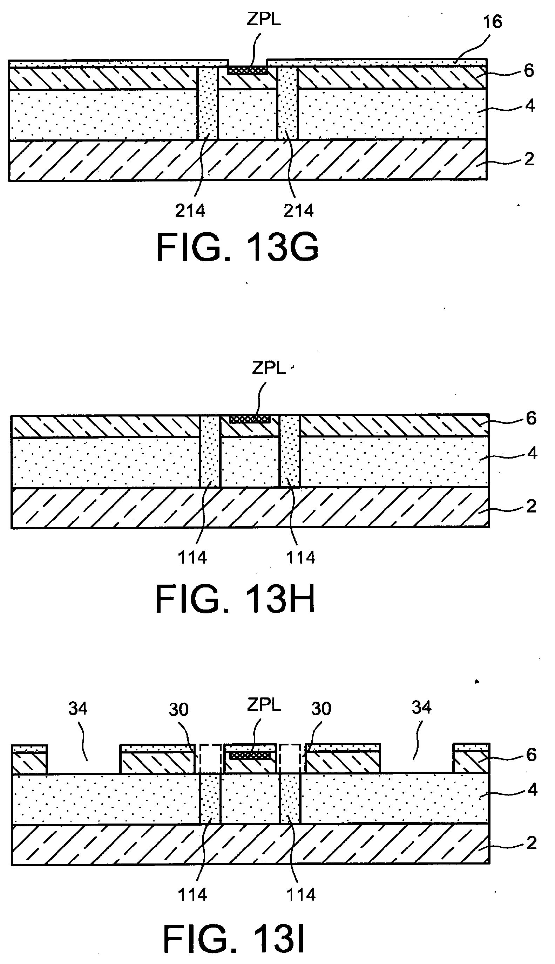

Les étapes représentées sur les figures 13E à 13H sont similaires à celles des figures 11E, 11F, 11G et 11I. Il est à noter que la couche 16 devrait présenter une marche dans la réalisation des figures 13F et 13G, mais celle-ci n'intervenant pas dans le procédé, celle-ci n'a pas été représentée.

L'élément ainsi obtenu est représenté sur la figure 13H.

Lors d'une étape suivante, on réalise des tranchées définissant la structure NEMS, ces tranchées sont réalisées au niveau des blocs de contact servant alors également de tranchées d'isolation électrique 30 entre le NEMS et les plots de contact. Ainsi ceux-ci sont gravés également, la couche active et les blocs de contact ne sont alors plus en contact.

Seule la partie des blocs de contact se trouvant dans la couche active peuvent être gravée comme cela est représenté sur la figure 13I.

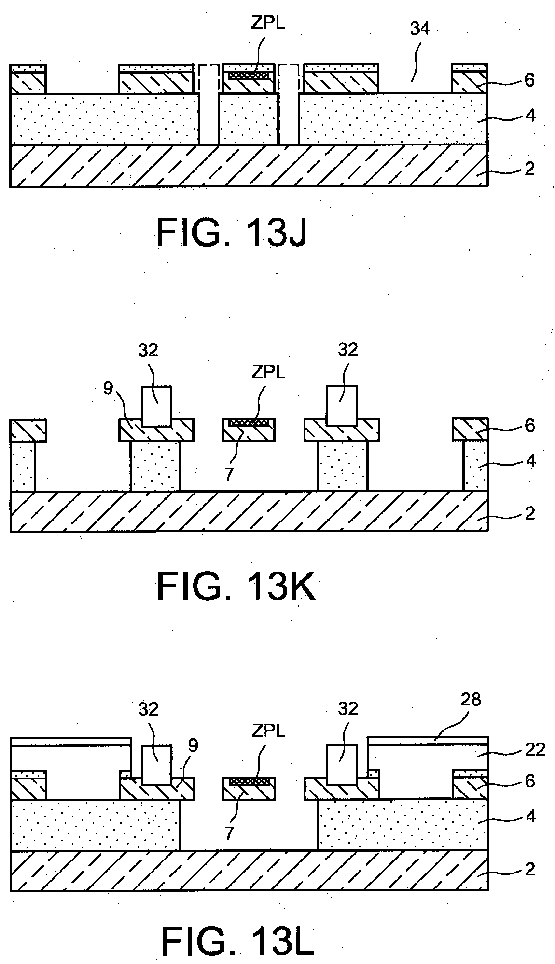

Il est aussi envisageable de graver les blocs de contact sur toute leur hauteur afin de les supprimer entièrement (figure 13J), éventuellement en ajoutant une étape de photolithographie supplémentaire pour protéger le reste de la structure pendant cette seconde étape de gravure.

Si l'on souhaite réaliser une structure NEMS avec une partie au moins partiellement suspendue, on peut réaliser une étape de gravure isotrope de la couche isolante 4 au niveau de la structure NEMS.

On peut prévoir préalablement cette étape de libération, de réaliser des contacts et/ou des connexions métalliques permettant de relier la structure NEMS à des plots électriques utilisés pour relier le dispositif à l'environnement extérieur de manière connue de l'homme du métier, par exemple dans le plan de la couche active 6.

En outre, il est possible de graver la couche active autour de la structure NEMS afin de l'isoler des autres structures NEMS, qui sinon seraient en contact électrique par la couche active.

Sur les figures 13I et 13J, une tranchée 34 assurant cette isolation entre les structures NEMS est formée.

De manière similaire au procédé des figures 11L à 11O", des interconnexions métalliques, peuvent être réalisées. Ces étapes ne seront pas répétées.

Les figures 13K et 13L son similaires aux figures 11O' et 11O".

La réalisation des blocs de contact dans les zones de structuration de la structure NEMS permet lors de la gravure simultanément de définir la structure NEMS et de supprimer le contact électrique entre la couche active et le substrat support. En revanche, cette réalisation requiert un alignement très précis si les dimensions des dispositifs sont très petites, par exemple de l'ordre du quelques dizaines de nm à quelques centaines de nm.

Dans les exemples des procédés des figures 11A à 11O" et 12A à 12D, les blocs de contact sont dans des zones dont la localisation par rapport à la structure mécanique est telle qu'elle n'impose pas de contraintes fortes sur la forme et la fabrication de cette dernière. En effet, les blocs de contact sont réalisés en périphérie de la structure mécanique et leur suppression au moins partielle ne requiert pas un alignement précis par rapport à la structure mécanique.

Nous allons maintenant décrire un autre exemple de procédé de réalisation qui diffère des procédés des figures 11A à 11O" et 12A à 12D, par la manière dont l'isolation électrique entre la couche 2 et la couche 6 est réalisée. Ce procédé est particulièrement intéressant dans le cas d'une fabrication collective. Les étapes de réalisation sont sinon identiques ou similaires aux étapes 11A à 11J.

Dans cet exemple, on réalise de manière collective plusieurs structures NEMS. Les blocs de contact sont réalisés dans des zones destinées à être éliminées lors de la séparation des structures NEMS.

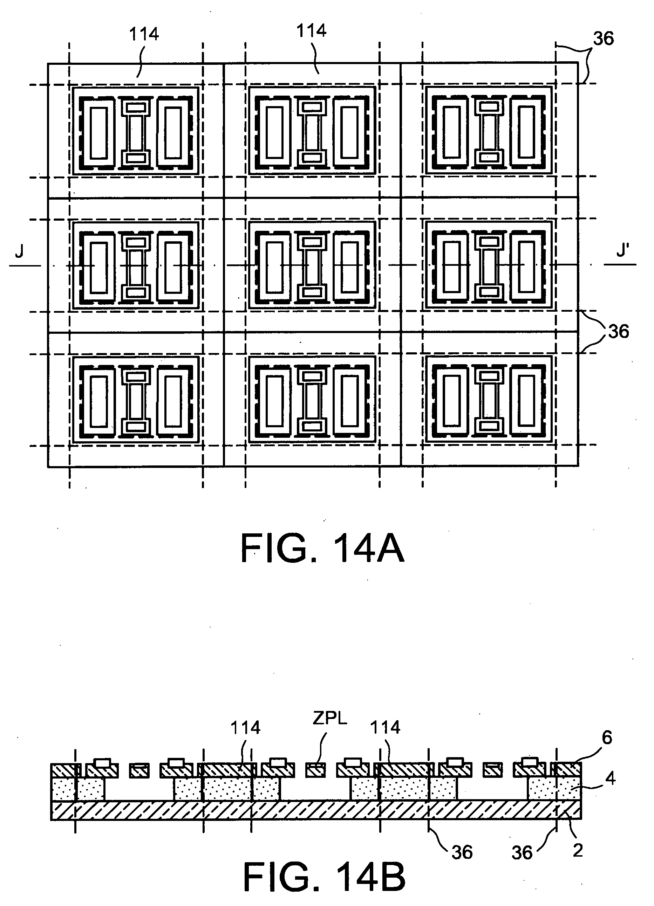

Sur la figure 14A, on peut voir un substrat sur lequel plusieurs structures mécaniques ont été réalisées simultanément.

Les blocs de contact 114 qui sont sous la forme de cadre, entourant les structures mécaniques et sont situés à l'extérieur de la partie fixe des structures mécaniques. Les blocs de contact forment un maillage, les structures mécaniques étant situées à l'intérieur des mailles. Chaque bloc de contact participe alors à la porosification de deux zones poreuses.

Toute autre forme de maillage peut être mise en oeuvre en fonction de la configuration des structures mécaniques et de leurs dispositions relatives.

La séparation des structures mécaniques est réalisée de manière à supprimer les plots de contact, ainsi on réalise à la fois la séparation des structures NEMS et l'isolation électrique de la couche 2 et de la couche active 6.

La séparation des structures mécaniques est par exemple obtenue par une opération de sciage. Par exemple, la lame de la scie présente une largeur au moins égale à celle des plots de contact 114 et est passée dans les plots de contact, ils sont alors éliminés. Ou un trait de scie est réalisé de part et d'autre des plots de contact comme cela est schématisé sur les figures 14A et 14B. Les plots de contact sont alors séparés des structures mécaniques. Les traits de scie sont symbolisés par les traits interrompus 36.

Les dispositifs de type MEMS ou NEMS ainsi réalisés peuvent avoir tout type d'application, en particulier ils peuvent former des capteurs d'humidité, des capteurs de gaz, des capteurs chimiques, des capteurs biologiques, des capteurs inertiels, avoir des fonctions optiques, thermiques.

Dans les exemples décrits, les blocs de contact s'arrêtent sur la couche support 2, mais il est envisageable de réaliser un ou des blocs de contact pénétrant, voire traversant la couche support 2.

En outre, on peut envisager de réaliser les blocs de contact à partir de la face arrière comme cela est schématisé sur la figure 19. Dans cet exemple, les blocs de contact 14 s'arrêtent sur la couche active 6. Les étapes suivantes de porosification sont inchangées. Si une isolation électrique est souhaitée entre la couche active et la couche support, les blocs de contact sont gravés en tout ou partie à partir de la face arrière.

Enfin pour interrompre le contact entre la couche active et le bloc de contact, il peut être envisagé de graver une tranchée directement dans le bloc de contact pour l'isoler du reste de la couche active.

## Revendications

1. Procédé de réalisation d'au moins une zone poreuse (ZP, ZPL) dans au moins une partie d'une couche active (6) en matériau conducteur ou semi-conducteur d'une structure microélectronique et/ou nanoélectronique , ladite couche active (6) formant une face avant d'un empilement, ledit empilement comportant une face arrière (2) en matériau conducteur ou semi-conducteur et une couche isolante électrique (4) interposée entre la couche active (6) et la face arrière (2), ledit procédé comportant les étapes :
a) réalisation d'au moins un contact électrique entre la face arrière (2) et la couche active (6) par formation d'au moins un bloc de contact (14, 114) en matériau conducteur électrique ou semi-conducteur à travers la couche isolante (4),
b) mise en place de l'empilement dans un bain électrochimique,
c) application d'un courant électrique entre la face arrière (2) et la couche active (6) à travers le bloc de contact (14, 114) de sorte à induire une porosification d'au moins une zone (ZP, ZPL) de la couche active (6).

2. Procédé de réalisation selon la revendication 1, dans lequel le bloc de contact est formé à partir de la face avant et/ou à partir de la face arrière (2).

3. Procédé de réalisation selon la revendication 1 ou 2, comportant après l'étape c) une étape d) de formation de la structure microélectronique et/ou nanoélectronique à partir de la couche active.

4. Procédé de réalisation selon l'une des revendications précédentes **caractérisé en ce que** l'empilement est un substrat SOI.

5. Procédé selon l'une des revendications 1 à 4, dans lequel le contact électrique entre la couche active (6) et la face arrière (2) est supprimé après l'étape c), la suppression du contact électrique étant avantageusement obtenue par retrait au moins partiel du bloc de contact (14, 114) de sorte à supprimer un contact mécanique entre la couche active (6) et/ou la face arrière (2) et le bloc de contact (14, 114).

6. Procédé selon la revendication 5, dans lequel le bloc de contact (14, 114) est partiellement gravé et/ou la couche active (6) est gravée autour du bloc de contact.

7. Procédé selon la revendication 5, dans lequel le bloc de contact est retiré par sciage.

8. Procédé selon la revendication 3 et la revendications 5 ou 6, dans lequel l'étape d) comporte une sous étape de gravure de la couche active (6) et dans lequel le retrait au moins partiel du bloc de contact a lieu simultanément à la gravure de la couche active (6).

9. Procédé selon l'une des revendications 1 à 8, dans lequel l'étape a) comporte la réalisation d'au moins un trou à travers l'empilement entre la face arrière (2) et la couche active (6), à travers la couche isolante (4) et le remplissage dudit trou par un matériau conducteur électrique ou semi-conducteur de sorte à former le bloc de contact (14, 114) établissant un contact électrique entre la face arrière (2) et la couche active (6), le remplissage dudit trou par un matériau conducteur électrique ou semi-conducteur étant avantageusement obtenu de préférence par épitaxie sélective ou non sélective, par électrolyse ou par dépôt de type dépôt chimique en phase vapeur.

10. Procédé selon l'une des revendications 1 à 9, dans lequel préalablement à l'étape a), au moins un trou est réalisé dans la couche isolante (4) atteignant la face arrière (2) et lors de l'étape a), la couche active (6) et le bloc de contact (14, 114) sont formés simultanément sur la couche isolante (4) et dans le trou respectivement, avantageusement par épitaxie.

11. Procédé selon la revendication 1 à 10, dans lequel le matériau du bloc de contact et celui de la couche active sont les mêmes.

12. Procédé selon l'une des revendications 1 à 11, dans lequel la face arrière est en silicium et le bloc de contact est réalisé en silicium, par épitaxie sur la face arrière.

13. Procédé selon l'une des revendications 1 à 11, dans lequel, lors de l'étape a), plusieurs blocs de contact (14) distincts sont réalisés à proximité de la zone à porosifier ou, lors de l'étape a) un seul bloc de contact (114) présentant un contour fermé est réalisé, la zone à porosifier étant à l'intérieur et/ou à l'extérieur du contour fermé ou, lors de l'étape a) un seul bloc de contact (114) présentant un contour discontinu est réalisé, la zone à porosifier étant à l'intérieur et/ou à l'extérieur du contour discontinu, ou une pluralité de blocs de contact délimitant entre eux une zone est réalisée, la zone à porosifier étant à l'intérieur et/ou à l'extérieur de la dite zone.

14. Procédé selon l'une des revendications 1 à 13, dans lequel lors de l'étape c) toute la surface de la couche active (6) est porosifiée et/ou la couche active (6) est porosifiée sur toute son épaisseur.

15. Procédé selon l'une des revendications 1 à 14, dans lequel préalablement à l'étape c) une couche de localisation (M) est formée au moins sur la couche active (6) pour délimiter au moins une zone de la couche active (6) à porosifier.

16. Procédé selon l'une des revendications 1 à 15 en combinaison avec la revendication 3, dans lequel les blocs de contact (14, 114) entourent la zone dans laquelle la structure microélectronique et/ou nanoélectronique est réalisée.

17. Procédé selon l'une des revendications 1 à 16 en combinaison avec la revendication 3, dans lequel la structure microélectronique et/ou nanoélectronique comporte au moins une partie suspendue (7) et une partie fixe (9), procédé dans lequel la zone poreuse est formée au moins en partie sur la partie suspendue (7) et éventuellement au moins en partie sur la partie fixe (9).

18. Procédé selon l'une des revendications 1 à 17 en combinaison avec la revendication 3, dans lequel la structure microélectronique et/ou nanoélectronique comporte au moins une partie suspendue (7) et une partie fixe (9), procédé dans lequel le bloc de contact (14, 114) est réalisé dans une zone entre la partie fixe (9) et la partie suspendue (7).

19. Procédé selon l'une des revendications 1 à 18 en combinaison avec la revendication 3, dans lequel l'étape d) comporte la réalisation d'interconnexions sur la couche active comprenant les sous-étapes :
- formation d'une couche diélectrique sur la zone poreuse (ZP, ZPL) et la couche active,
- formation d'un masque sur la couche diélectrique
- gravure du masque et de la couche diélectrique jusqu'à atteindre la couche active (6),
- formation et structuration d'un matériau conducteur dans les gravures pour former les interconnexions.

20. Procédé selon l'une des revendications 1 à 19, dans lequel l'empilement comporte une ou plusieurs couches entre la face arrière (2) et la couche isolante (4) telles qu'une continuité électrique entre la face arrière (4) et la couche active (6) est assurée après l'étape a).

21. Procédé selon l'une des revendications 1 à 20 destiné à la réalisation de plusieurs structures microélectroniques et/ou nanoélectroniques, les blocs de contacts étant réalisés entre les zones dans lesquelles les structures microélectroniques et/nanoélectroniques sont réalisées.

22. Procédé selon la revendication 21, dans lequel le contact électrique entre la couche active (6) et la face arrière (2) est supprimé après l'étape c) par séparation des structures microélectroniques et/ou nanoélectroniques, ladite séparation étant avantageusement obtenue par sciage, par deux traits de scie (36) de part et d'autre des plots de contact (14, 114) de sorte à séparer les blocs de contacts des structures microélectronique et/ou nanoélectroniques ou par un trait de scie ayant une largeur au moins égale à la dimension transversale des blocs de contact (14, 114).

## Patentansprüche

1. Verfahren zur Realisierung wenigstens einer porösen Zone (ZP, ZPL) in wenigstens einem Teil einer aktiven Schicht (6) aus Leiter- oder Halbleitermaterial einer mikroelektronischen und/oder nanoelektronischen Struktur, wobei die aktive Schicht (6) eine Vorderfläche eines Stapels bildet, wobei der Stapel eine Rückfläche (2) aus Leiter- oder Halbleitermaterial sowie eine elektrisch isolierende Schicht (4) umfasst, die zwischen der aktiven Schicht (6) und der Rückfläche (2) eingefügt ist, wobei das Verfahren die folgenden Schritte umfasst:
a) Realisieren wenigstens eines elektrischen Kontakts zwischen der Rückfläche (2) und der aktiven Schicht (6) durch Bilden wenigstens eines Kontaktblocks (14, 114) aus elektrisch leitendem oder Halbleiter-Material durch die isolierende Schicht (4) hindurch,
b) Platzieren des Stapels in einem elektrochemischen Bad,
c) Anlegen eines elektrischen Stroms zwischen der Rückfläche (2) und der aktiven Schicht (6) durch den Kontaktblock (14, 114) hindurch derart, dass eine Porosifizierung wenigstens einer Zone (ZP, ZPL) der aktiven Schicht (6) induziert wird.

2. Verfahren zur Realisierung nach Anspruch 1, bei dem der Kontaktblock ausgehend von der Vorderfläche und/oder ausgehend von der Rückfläche (2) gebildet wird.

3. Verfahren zur Realisierung nach Anspruch 1 oder 2, umfassend, nach dem Schritt c), einen Schritt d) des Bildens der mikroelektronischen und/oder nanoelektronischen Struktur ausgehend von der aktiven Schicht.

4. Verfahren zur Realisierung nach einem der vorhergehenden Ansprüche, **dadurch gekennzeichnet, dass** der Stapel ein SOI-Substrat ist.

5. Verfahren nach einem der Ansprüche 1 bis 4, bei dem der elektrische Kontakt zwischen der aktiven Schicht (6) und der Rückfläche (2) nach dem Schritt c) entfernt wird, wobei das Entfernen des elektrischen Kontakts vorzugsweise erzielt wird durch wenigstens partielles Abnehmen des Kontaktblocks (14, 114) derart, dass ein mechanischer Kontakt zwischen der aktiven Schicht (6) und/oder der Rückfläche (2) und dem Kontaktblock (14, 114) entfernt wird.

6. Verfahren nach Anspruch 5, bei dem der Kontaktblock (14, 114) partiell graviert wird und/oder die aktive Schicht (6) um den Kontaktblock herum graviert wird.

7. Verfahren nach Anspruch 5, bei dem der Kontaktblock durch Sägen abgenommen wird.

8. Verfahren nach Anspruch 3 und Anspruch 5 oder 6, bei dem der Schritt d) einen Teilschritt des Gravierens der aktiven Schicht (6) umfasst, und bei dem das wenigstens partielle Abnehmen des Kontaktblocks gleichzeitig mit dem Gravieren der aktiven Schicht (6) erfolgt.

9. Verfahren nach einem der Ansprüche 1 bis 8, bei dem der Schritt a) die Realisierung wenigstens eines Lochs durch den Stapel hindurch zwischen der Rückfläche (2) und der aktiven Schicht (6) durch die isolierende Schicht (4) sowie das Füllen des Lochs mit einem elektrisch leitenden oder Halbleiter-Material derart umfasst, dass der Kontaktblock (14, 114) gebildet wird, der einen elektrischen Kontakt zwischen der Rückfläche (2) und der aktiven Schicht (6) herstellt, wobei das Füllen des Lochs mit einem elektrisch leitenden oder einem Halbleiter-Material vorteilhafterweise bevorzugt durch selektive oder nicht-selektive Epitaxie, durch Elektrolyse oder durch eine Abscheidung vom Typ chemische Dampfphasenabscheidung erzielt wird.

10. Verfahren nach einem der Ansprüche 1 bis 9, bei dem vor dem Schritt a) wenigstens ein Loch in der isolierenden Schicht (4) realisiert wird, das die Rückfläche (2) erreicht, und dass während des Schritts a) die aktive Schicht (6) und der Kontaktblock (14, 114) gleichzeitig auf der isolierenden Schicht (4) beziehungsweise in dem Loch gebildet werden, vorzugsweise durch Epitaxie.

11. Verfahren nach Anspruch 1 bis 10, bei dem das Material des Kontaktblocks und jenes der aktiven Schicht identisch sind.

12. Verfahren nach einem der Ansprüche 1 bis 11, bei dem die Rückfläche aus Silizium ist, und der Kontaktblock aus Silizium realisiert ist, durch Epitaxie auf der Rückfläche.

13. Verfahren nach einem der Ansprüche 1 bis 11, bei dem während des Schritts a) mehrere verschiedene Kontaktblöcke (14) in der Nähe der zu porosifizierenden Zone realisiert werden, oder während des Schritts a) ein einziger Kontaktblock (114) realisiert wird, der eine geschlossene Kontur aufweist, wobei die zu porosifizierende Zone innerhalb oder außerhalb der geschlossenen Kontur ist, oder während des Schritts a) ein einziger Kontaktblock (114) realisiert wird, der eine diskontinuierliche Kontur aufweist, wobei die zu porosifizierende Zone innerhalb und/oder außerhalb der diskontinuierlichen Kontur ist, oder eine Mehrzahl von Kontaktblöcken realisiert wird, die eine Zone zwischen sich begrenzen, wobei die zu porosifizierende Zone innerhalb und/oder außerhalb der Zone ist.

14. Verfahren nach einem der Ansprüche 1 bis 13, bei dem während des Schritts c) die gesamte Oberfläche der aktiven Schicht (6) porosifiziert wird und/oder die aktive Schicht (6) über ihre gesamte Dicke porosifiziert wird.

15. Verfahren nach einem der Ansprüche 1 bis 14, bei dem vor dem Schritt c) eine Lokalisierungsschicht (M) wenigstens auf der aktiven Schicht (6) gebildet wird, um wenigstens eine zu porosifizierende Zone der aktiven Schicht (6) zu begrenzen.

16. Verfahren nach einem der Ansprüche 1 bis 15 in Kombination mit Anspruch 3, bei dem die Kontaktblöcke (14, 114) die Zone umgeben, in der die mikroelektronische und/oder nanoelektronische Struktur realisiert ist.

17. Verfahren nach einem der Ansprüche 1 bis 16 in Kombination mit Anspruch 3, bei dem die mikroelektronische und/oder nanoelektronische Struktur wenigstens einen aufgehängten Teil (7) und einen festen Teil (9) umfasst, wobei bei dem Verfahren die poröse Zone wenigstens teilweise bei dem aufgehängten Teil (7) und gegebenenfalls wenigstens teilweise bei dem festen Teil (9) gebildet wird.

18. Verfahren nach einem der Ansprüche 1 bis 17 in Kombination mit Anspruch 3, bei dem die mikroelektronische und/oder nanoelektronische Struktur wenigstens einen aufgehängten Teil (7) und einen festen Teil (9) umfasst, wobei bei dem Verfahren der Kontaktblock (14, 114) in einer Zone zwischen dem festen Teil (9) und dem aufgehängten Teil (7) realisiert wird.

19. Verfahren nach einem der Ansprüche 1 bis 18 in Kombination mit Anspruch 3, bei dem der Schritt d) die Realisierung von Zwischenverbindungen auf der aktiven Schicht umfasst, umfassend die folgenden Teilschritte:
- Bilden einer dielektrischen Schicht auf der porösen Zone (ZP, ZPL) und der aktiven Schicht,
- Bilden einer Maske auf der dielektrischen Schicht,
- Gravieren der Maske und der dielektrischen Schicht, bis die aktive Schicht (6) erreicht wird,
- Bilden und Strukturieren eines Leitermaterials in den Gravuren, um die Zwischenverbindungen zu bilden.

20. Verfahren nach einem der Ansprüche 1 bis 19, bei dem der Stapel eine oder mehrere Schichten zwischen der Rückfläche (2) und der isolierenden Schicht (4) derart umfasst, dass eine elektrische Kontinuität zwischen der Rückfläche (4) und der aktiven Schicht (6) nach dem Schritt a) sichergestellt wird.

21. Verfahren nach einem der Ansprüche 1 bis 20 zur Realisierung von mehreren mikroelektronischen und/oder nanoelektronischen Strukturen, wobei die Kontaktblöcke zwischen den Zonen realisiert werden, in denen die mikroelektronischen und/oder nanoelektronischen Strukturen realisiert werden.

22. Verfahren nach Anspruch 21, bei dem der elektrische Kontakt zwischen der aktiven Schicht (6) und der Rückfläche (2) nach dem Schritt c) entfernt wird durch Separieren der mikroelektronischen und/oder nanoelektronischen Strukturen, wobei die Separierung vorzugsweise durch Sägen an zwei Sägeeinschnitten (36) auf beiden Seiten der Kontaktblöcke (14, 114) derart erzielt wird, dass die Kontaktblöcke von den mikroelektronischen und/oder nanoelektronischen Strukturen separiert werden, oder mit einem Sägeeinschnitt, der eine Breite wenigstens gleich der transversalen Abmessung der Kontaktblöcke (14, 114) hat.

## Claims

1. A process for making at least one porous area (ZP, ZPL) in at least one part of an active layer (6) of conducting or semi-conducting material of a microelectronic and/or nanoelectronic structure, said active layer (6) forming a front face of a stack, said stack comprising a back face (2) of conducting or semi-conducting material and an electrically insulating layer (4) interposed between the active layer (6) and the back face (2), said process comprising the steps of:
a) making at least one electrical contact between the back face (2) and the active layer (6) by forming at least one contact block (14, 114) of electrically conducting or semi-conducting material through the insulating layer (4),
b) placing the stack into an electrochemical bath,
c) applying an electrical current between the back face (2) and the active layer (6) through the contact block (14, 114) so as to cause porosification of at least one area (ZP, ZPL) of the active layer (6).

2. The process according to claim 1, wherein the contact block is formed from the front face and/or from the back face (2).

3. The process according to claim 1 or 2, comprising after step c), a step d) of forming the microelectronic and/or nanoelectronic structure from the active layer.

4. The process according to one of the preceding claims, wherein the stack is an SOI substrate.

5. The process according to one of claims 1 to 4, wherein the electrical contact between the active layer (6) and the back face (2) is removed after step c), the step of removing the electrical contact being advantageously achieved by at least partially withdrawing the contact block (14, 114) so as to remove a mechanical contact between the active layer (6) and/or the back face (2) and the contact block (14, 114).

6. The process according to claim 5, wherein the contact block (14, 114) is partially etched or/and the active layer (6) is etched around the contact block.

7. The process according to claim 5, wherein the contact block is withdrawn by sawing.

8. The process according to claim 3 and claim 5 or claim 6, wherein step d) comprises a sub-step of etching the active layer (6) and a step of at least partially withdrawing the contact block that takes place simultaneously to etching the active layer (6).

9. The process according to one of claims 1 to 8, wherein step a) comprises making at least one hole through the stack between the back face (2) and the active layer (6), through the insulation layer (4) and filling said hole with an electrically conducting or semi-conducting material so as to form the contact block (14, 114) making an electrical contact between the back face (2) and the active layer (6), advantageously the filling said hole by an electrically conducting or semi-conducting material is preferably achieved by selective or non-selective epitaxy, by electrolysis or by chemical vapour type deposition.

10. The process according to one of claims 1 to 9, wherein prior to step a), at least one hole is made in the insulation layer (4) reaching the back face (2) and during step a), the active layer (6) and the contact block (14, 114) are simultaneously formed onto the insulating layer (4) and in the hole respectively, advantageously through epitaxy.

11. The process according to one of claims 1 to 10 wherein the material of the contact block and that of the active layer are the same.

12. The process according to one of claims 1 to 11, wherein the back face is of silicon and the contact block is made of silicon, through epitaxy on the back face.

13. The process according to one of claims 1 to 12, wherein, during step a), several distinct contact blocks (14) are made in proximity to the area to be porosified, or wherein, during step a), a single contact block (114) having a closed outline is made, the area to be porosified being inside and/or outside the closed outline, or wherein, during step a), a single contact block (114) having a discontinuous outline is made, the area to be porosified being inside and/or outside the discontinuous outline, or a plurality of contact blocks bounding an area between each other is made, the area to be porosified being inside and/or outside said area.

14. The process according to one of claims 1 to 13, wherein during step c), the entire surface of the active layer (6) is porosified and/or the active layer (6) is porosified throughout its thickness.

15. The process according to one of claims 1 to 14, wherein prior to step c), a location layer (M) is formed at least on the active layer (6) to bound at least one area of the active layer (6) to be porosified.

16. The process according to one of claims 1 to 15 in combination with claim 3, wherein the contact blocks (14, 114) surround the area wherein the microelectronic and/or nanoelectronic structure is made.

17. The process according to one of claims 1 to 16 in combination with claim 3, wherein the microelectronic and/or nanoelectronic structure comprises at least one suspended part (7) and a fixed part (9), in which process the porous area is formed at least partly on the suspended part (7) and possibly at least partly on the fixed part (9).

18. The process according to one of claims 1 to 17 in combination with claim 3,wherein the microelectronic and/or nanoelectronic structure comprises at least one suspended part (7) and a fixed part (9), in which process the contact block (14, 114) is made in an area between the fixed part (9) and the suspended part (7).

19. The process according to one of claims 1 to 18 in combination with claim 3, wherein step d) comprises making interconnections on the active layer comprising the sub-steps of:
- forming a dielectric layer on the porous area (ZP, ZPL) and the active layer,
- forming a mask on the dielectric layer
- etching the mask and the dielectric layer up to the active layer (6),
- forming and structuring a conducting material in the etchings to form the interconnections.

20. The process according to one of claims 1 to 19, wherein the stack comprises one or more layers between the back face (2) and the insulating layer (4) such that an electrical continuity between the back face (4) and the active layer (6) is ensured after step a).

21. The process according to one of claims 1 to 20, wherein several microelectronic and/or nanoelectronic structures are made and wherein the contact blocks are made between the areas wherein the microelectronic and/or nanoelectronic structures are made.

22. The process according to claim 21, wherein the electrical contact between the active layer (6) and the back face (2) is removed after step c) by separating the microelectronic and/or nanolectronic structuresn said separation being achieving by sawing, by two saw cuts (36) on either side of the contact pads (14, 114) so as to separate the contact blocks from the microelectronic and/or nanoelectronic structures or by a saw cut having a width at least equal to the transverse dimension of the contact blocks (14, 114).
